(19) **Europäisches Patentamt European Patent Office Office européen des brevets**

(11) **EP 4 716 037 A1**

(12) **EUROPEAN PATENT APPLICATION**
published in accordance with Art. 153(4) EPC

(43) Date of publication:
**25.03.2026 Bulletin 2026/13**

(21) Application number: **24810750.0**

(22) Date of filing: **10.04.2024**

(51) International Patent Classification (IPC):
**H01S 5/183** (2006.01)     **H01L 33/14** (2010.01)

(52) Cooperative Patent Classification (CPC):
**H01S 5/183; H10H 20/816**

(86) International application number:
**PCT/JP2024/014537**

(87) International publication number:
**WO 2024/241742 (28.11.2024 Gazette 2024/48)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.05.2023 JP 2023082716**

(71) Applicant: **Sony Semiconductor Solutions
Corporation
Atsugi-shi, Kanagawa 243-0014 (JP)**

(72) Inventors:
• **YOKOYAMA, Hiroki**
**Kikuchi-gun, Kumamoto 869-1102 (JP)**
• **KAWAMURA, Shunya**
**Kikuchi-gun, Kumamoto 869-1102 (JP)**
• **YOKOTA, Tomohiro**
**Kikuchi-gun, Kumamoto 869-1102 (JP)**
• **KUDO, Hiroki**
**Kikuchi-gun, Kumamoto 869-1102 (JP)**
• **ITO, Ryo**
**Kikuchi-gun, Kumamoto 869-1102 (JP)**
• **AOYAGI, Hidekazu**
**Kikuchi-gun, Kumamoto 869-1102 (JP)**

(74) Representative: **D Young & Co LLP
3 Noble Street
London EC2V 7BQ (GB)**

(54) **SURFACE LIGHT-EMITTING ELEMENT**

(57)     To provide a surface-emitting element capable of suppressing occurrence of cracks due to an oxide confinement layer during driving and/or mounting.

A surface-emitting element according to the present technology includes a first structure including a first semiconductor structure, a second structure stacked with the first structure and including a second semiconductor structure, and a third structure arranged between the first and second structures and including a light-emitting layer, in which an oxide confinement layer is provided between a surface of the first structure on a side opposite a light-emitting layer side and the light-emitting layer and/or between a surface of the second structure on a side opposite the light-emitting layer side and the light-emitting layer, the oxide confinement layer including a non-oxidized region, and an oxidized region surrounding at least a part of the non-oxidized region, and the oxidized region has a plurality of tapered portions whose thickness decreases toward inner peripheral ends. With the surface-emitting element according to the present technology, a surface-emitting element capable of suppressing occurrence of cracks due to an oxide confinement layer during driving and/or mounting can be provided.

EP 4 716 037 A1

# FIG. 1

**Description**

TECHNICAL FIELD

The technology according to the present disclosure (hereinafter also referred to as the "present technology") relates to a surface-emitting element.

BACKGROUND ART

Conventionally, for example, surface-emitting elements capable of obtaining a surface-emission output, such as a surface-emitting laser and a light-emitting diode, are known.
Some conventional surface-emitting elements include an oxide confinement layer, in which at least a part of a non-oxidized region is surrounded by an oxidized region.
For example, Patent Document 1 discloses a surface-emitting element in which an oxidized region includes an oxide confinement layer having a tapered portion in an inner peripheral portion.
For example, Patent Document 2 discloses a surface-emitting element in which an oxidized region includes is generally tapered from an inner peripheral end to an outer peripheral end.

CITATION LIST

PATENT DOCUMENT

Patent Document 1: Japanese Patent Application Laid-Open No. 2004-356438
Patent Document 2: Japanese Patent Application Laid-Open No. 2009-206480

SUMMARY OF THE INVENTION

PROBLEMS TO BE SOLVED BY THE INVENTION

In the conventional surface-emitting elements, there is room for improvement in terms of suppressing occurrence of cracks due to an oxide confinement layer during driving and/or mounting.
Therefore, a main object of the present technology is to provide a surface-emitting element capable of suppressing occurrence of cracks due to an oxide confinement layer during driving and/or mounting.

SOLUTIONS TO PROBLEMS

The present technology provides a surface-emitting element including:

a first structure including a first semiconductor structure;
a second structure stacked with the first structure and including a second semiconductor structure; and
a third structure arranged between the first and second structures and including a light-emitting layer, in which
an oxide confinement layer is provided between a surface of the first structure on a side opposite a light-emitting layer side and the light-emitting layer and/or between a surface of the second structure on a side opposite the light-emitting layer side and the light-emitting layer, the oxide confinement layer including:

a non-oxidized region; and
an oxidized region surrounding at least a part of the non-oxidized region, and
the oxidized region has a plurality of tapered portions whose thickness decreases toward inner peripheral ends.

The plurality of tapered portions may be located at different positions in a radial direction of the oxidized region.
The oxidized region may have a first tapered portion as the tapered portion in an outer peripheral portion.
The oxidized region may have a second tapered portion as the tapered portion in an inner peripheral portion.
A taper angle of the first tapered portion may be larger than a taper angle of the second tapered portion.

$$d1(x_{11}) > d1(x_{12}) > \cdots > d1(x_{1n})$$

and/or

$$d2(x_{11}) > d2(x_{12}) > \cdots > d2(x_{1n})$$

may be satisfied, where a thickness of a first portion for each x-coordinate and a thickness of a second portion for each x-coordinate in a case where a plane located at an arbitrary position of the oxide confinement layer in a thickness direction and parallel to an in-plane direction is defined as a reference plane, a portion of the first tapered portion on one side of the reference plane is defined as the first portion, a portion on another side is defined as the second portion, and an x-axis is set in a direction from an outer peripheral end to an inner peripheral end of the oxidized region along the reference plane are denoted by d1(x) and d2 (x), respectively, and $x_{11} < x_{12} < \cdots < x_{1n}$.

$$[\{d1(0) + d2(0)\} - \{d1(x_{1max}) + d2(x_{1max})\}]/x_{1max} \geq 0.05$$

may be satisfied, where a thickness of the first portion for each x-coordinate and a thickness of the second portion for each x-coordinate in a case where a plane located at an arbitrary position of the oxide confinement layer in a thickness direction and parallel to an in-plane direction is defined as a reference plane, an x-axis is set in a direction from an outer peripheral end to an inner peripheral end of the oxidized region along the reference plane, an x-coordinate of an outer peripheral end of the first tapered portion is 0, and an x-coordinate of an inner peripheral end of the first tapered portion is $x_{1max}$ are denoted by d1(x) and d2(x), respectively.

$$[d1(x_{21}) + d2(x_{21})] > [d1(x_{22}) + d2(x_{22})] > \cdots > [d1(x_{2n}) + d2(x_{2n})]$$

may be satisfied, where a thickness of a first portion for each x-coordinate and a thickness of a second portion for each x-coordinate in a case where a plane located at an arbitrary position of the oxide confinement layer in a thickness direction and parallel to an in-plane direction is defined as a reference plane, a portion of the second tapered portion on one side of the reference plane is defined as the first portion, a portion on another side is defined as the second portion, and an x-axis is set in a direction from an outer peripheral end to an inner peripheral end of the oxidized region along the reference plane are denoted by d1(x) and d2 (x), respectively, and $x_{21} < x_{22} < \cdots < x_{2n}$.

The oxidized region may have a middle peripheral portion between the outer peripheral portion and the inner peripheral portion.
The middle peripheral portion may have a constant thickness.
The middle peripheral portion may have a third tapered portion as the tapered portion.

$$[d1(x_{31}) + d2(x_{31})] \geq [d1(x_{32}) + d2(x_{32})] \geq \cdots \geq [d1(x_{3n}) + d2(x_{3n})]$$

may be satisfied, where a thickness of a first portion for each x-coordinate and a thickness of a second portion for each x-coordinate in a case where a plane located at an arbitrary position of the oxide confinement layer in a thickness direction and parallel to an in-plane direction is defined as a reference plane, a portion of the middle peripheral portion on one side of the reference plane is defined as the first portion, a portion on another side is defined as the second portion, and an x-axis is set in a direction from an outer peripheral end to an inner peripheral end of the oxidized region along the reference plane are denoted by d1(x) and d2 (x), respectively, and $x_{31} < x_{32} < \cdots < x_{3n}$.

$$[\{d1(x_{3min}) + d2(x_{3min})\} - \{d1(x_{3max}) + d2(x_{3max})\}]/(x_{3max} - x_{3min}) \leq 0.01$$

may be satisfied, where a thickness of a first portion for each x-coordinate and a thickness of a second portion for each x-coordinate in a case where a plane located at an arbitrary position of the oxide confinement layer in a thickness direction and parallel to an in-plane direction is defined as a reference plane, a portion of the third tapered portion on one side of the reference plane is defined as the first portion, a portion on another side is defined as the second portion, an x-axis is set in a direction from an outer peripheral end to an inner peripheral end of the oxidized region along the reference plane, and an x-coordinate of an outer peripheral end of the third tapered portion is $x_{3min}$, and an x-coordinate of an inner peripheral end of the third tapered portion is $x_{3max}$ are denoted by d1(x) and d2(x), respectively.

At least one of the plurality of tapered portions may be not parallel to an in-plane direction on both of one surface and another surface facing each other in the thickness direction.

At least one of the plurality of tapered portions need not be parallel to an in-plane direction on one of one surface and another surface facing each other in a thickness direction and may be parallel to the in-plane direction on another of the one surface and the another surface.

The non-oxidized region may have a multilayer structure in which a plurality of semiconductor layers having different Al compositions is stacked.

In the multilayer structure, the Al composition of the semiconductor layer at a predetermined position in a stacking direction of the first and second structures may be the highest, and the Al composition of the semiconductor layer closer to the semiconductor layer at the predetermined position may be higher.

The plurality of semiconductor layers may be an odd number of semiconductor layers, and the predetermined position may be a central position in the stacking direction.

The plurality of semiconductor layers may be at least three semiconductor layers, and the predetermined position may be a position of one end or another end in the stacking direction.

The plurality of semiconductor layers may be at least three semiconductor layers, and the predetermined position may be a position other than one end or another end in the stacking direction.

BRIEF DESCRIPTION OF DRAWINGS

Fig. 1 is a cross-sectional view of a surface-emitting element according to Example 1 of an embodiment of the present technology.

Fig. 2 is a plan view of the surface-emitting element according to Example 1 of the embodiment of the present technology.

Fig. 3 is a cross-sectional view of an oxide confinement layer of the surface-emitting element according to Example 1 of the embodiment of the present technology.

Fig. 4 is a diagram for explaining an oxidized region of the oxide confinement layer of the surface-emitting element according to Example 1 of the embodiment of the present technology.

Fig. 5 is a flowchart for explaining an example of a method for manufacturing the surface-emitting element according to Example 1 of the embodiment of the present technology.

Fig. 6 is a cross-sectional view of each step of the example of the method for manufacturing the surface-emitting element according to Example 1 of the embodiment of the present technology.

Fig. 7 is a cross-sectional view of an oxidation layer used to manufacture the surface-emitting element according to Example 1 of the embodiment of the present technology.

Fig. 8 is a cross-sectional view of each step of the example of the method for manufacturing the surface-emitting element according to Example 1 of the embodiment of the present technology.

Fig. 9 is a cross-sectional view of each step of the example of the method for manufacturing the surface-emitting element according to Example 1 of the embodiment of the present technology.

Fig. 10 is a cross-sectional view of each step of the example of the method for manufacturing the surface-emitting element according to Example 1 of the embodiment of the present technology.

Fig. 11 is a cross-sectional view of each step of the example of the method for manufacturing the surface-emitting element according to Example 1 of the embodiment of the present technology.

Fig. 12 is a cross-sectional view of an oxide confinement layer of a surface-emitting element according to Modification 1 of Example 1 of the embodiment of the present technology.

Fig. 13 is a cross-sectional view of an oxide confinement layer of a surface-emitting element according to Modification 2 of Example 1 of the embodiment of the present technology.

Fig. 14 is a cross-sectional view of an oxide confinement layer of a surface-emitting element according to Modification 3 of Example 1 of the embodiment of the present technology.

Fig. 15 is a cross-sectional view of an oxide confinement layer of a surface-emitting element according to Modification 4 of Example 1 of the embodiment of the present technology.

Fig. 16 is a cross-sectional view of an oxide confinement layer of a surface-emitting element according to Modification 5 of Example 1 of the embodiment of the present technology.

Fig. 17 is a cross-sectional view of an oxide confinement layer of a surface-emitting element according to Modification 6 of Example 1 of the embodiment of the present technology.

Fig. 18 is a cross-sectional view of an oxide confinement layer of a surface-emitting element according to Modification 7 of Example 1 of the embodiment of the present technology.

Fig. 19 is a cross-sectional view of an oxide confinement layer of a surface-emitting element according to Modification 8 of Example 1 of the embodiment of the present technology.

Fig. 20 is a cross-sectional view of a surface-emitting element according to Example 2 of the embodiment of the present technology.

Fig. 21 is a cross-sectional view of a surface-emitting element according to Example 3 of the embodiment of the present technology.

Fig. 22 is a cross-sectional view of a surface-emitting element according to Example 4 of the embodiment of the present technology.

Fig. 23 is a cross-sectional view of a surface-emitting element according to Example 5 of the embodiment of the present technology.

Fig. 24 is a cross-sectional view of a surface-emitting element according to Example 6 of the embodiment of the present technology.

Fig. 25 is a cross-sectional view of a surface-emitting element according to Example 7 of the embodiment of the present technology.

Fig. 26 is a cross-sectional view of a surface-emitting element according to Example 8 of the embodiment of the present technology.

Fig. 27 is a cross-sectional view of a surface-emitting element according to Example 9 of the embodiment of the present technology.

Fig. 28 is a cross-sectional view of a surface-emitting element according to Example 10 of the embodiment of the present technology.

Fig. 29 is a cross-sectional view of a surface-emitting element according to Example 11 of the embodiment of the present technology.

Fig. 30 is a cross-sectional view of a surface-emitting element according to Example 12 of the embodiment of the present technology.

Fig. 31 is a cross-sectional view of a surface-emitting element according to Example 13 of the embodiment of the present technology.

Fig. 32 is a cross-sectional view of a light source apparatus including the surface-emitting element according to Example 1 of the embodiment of the present technology.

Fig. 33 is a diagram for explaining a taper angle of each tapered portion.

Fig. 34 is a diagram illustrating an application example of the surface-emitting element according to Example 1 of the embodiment of the present technology to a distance measuring apparatus.

Fig. 35 is a block diagram depicting an example of schematic configuration of a vehicle control system.

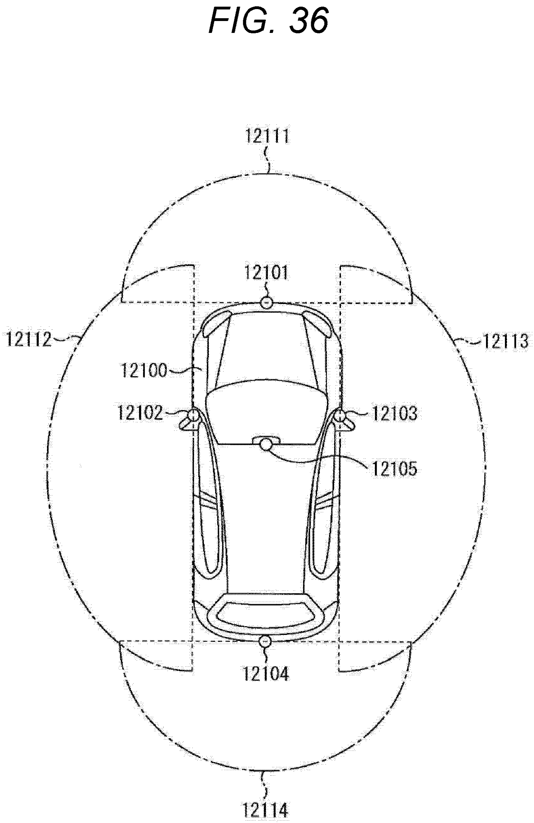

Fig. 36 is an explanatory diagram illustrating an example of installation positions of the distance measuring apparatus.

## MODE FOR CARRYING OUT THE INVENTION

A preferred embodiment of the present technology will be described in detail hereinafter with reference to the accompanying drawings. Note that, in the present specification and drawings, components having substantially the same functional configurations will be denoted by the same reference numerals, and redundant description thereof is omitted. The embodiment that will be described hereinafter is a representative embodiment of the present technology, and the scope of the present technology is not to be narrowly interpreted according to this embodiment. Even in a case where it is described in the present specification that the surface-emitting element according to the present technology exhibits a plurality of effects, the surface-emitting element according to the present technology may exhibit at least one effect. The effects described in the present specification are merely examples and are not limiting, and other effects may also be produced.

Furthermore, description will be provided in the following order.

0. Introduction
1. Surface-Emitting Element According to Example 1 of Embodiment of Present Technology
1.5. Surface-Emitting Elements According to Modifications 1 to 8 of Example 1 of Embodiment of Present Technology
2. Surface-Emitting Element According to Example 2 of Embodiment of Present Technology
3. Surface-Emitting Element According to Example 3 of Embodiment of Present Technology
4. Surface-Emitting Element According to Example 4 of Embodiment of Present Technology
5. Surface-Emitting Element According to Example 5 of Embodiment of Present Technology
6. Surface-Emitting Element According to Example 6 of Embodiment of Present Technology
7. Surface-Emitting Element According to Example 7 of Embodiment of Present Technology
8. Surface-Emitting Element According to Example 8 of Embodiment of Present Technology
9. Surface-Emitting Element According to Example 9 of Embodiment of Present Technology
10. Surface-Emitting Element According to Example 10 of Embodiment of Present Technology

11. Surface-Emitting Element According to Example 11 of Embodiment of Present Technology

12. Surface-Emitting Element According to Example 12 of Embodiment of Present Technology

13. Surface-Emitting Element According to Example 13 of Embodiment of Present Technology

14. Light Source Apparatus Including Surface-Emitting Element According to Example 1 of Embodiment of Present Technology

15. Other Modifications of Present Technology

16. Example of Application to Electronic Device

17. Example in Which Surface-Emitting Element Is Employed in Distance Measuring Apparatus

18. Example in Which Distance Measuring Apparatus Is Mounted on Mobile Body

<0. Introduction>

Conventionally, for example, in GaAs-based (a material system lattice-matching GaAs) surface-emitting elements (surface-emitting lasers, light-emitting diodes, etc.), an oxide confinement layer is widely and generally used as a current confinement layer. Since an oxide confinement layer as a current confinement layer greatly affects electro-optical characteristics, various structures for improving the performance have been proposed.

For example, some conventional techniques for controlling a shape of an oxidized region of an oxide confinement layer have been reported.

The inventors have found that in a portion of an oxidized region where thickness is uniform or close to uniform, stress is likely to concentrate during driving and/or mounting, and cracks are likely to occur in an element (for example, a mesa including an oxide confinement layer; the same applies hereinafter). From the viewpoint of this new knowledge, conventional techniques for controlling a shape of an oxidized region have been considered.

For example, in the surface-emitting element described in Patent Document 1, the oxidized region of the oxide confinement layer has a tapered portion at an oxidation termination portion, and it is possible to locally alleviate stress applied during driving and/or mounting at the oxidation termination portion. In the surface-emitting element, however, the stress cannot be alleviated in a portion other than the oxidation termination portion of the oxidized region, and cracks might occur in the element. That is, in the surface-emitting element, there is room for improvement in terms of suppressing occurrence of cracks due to an oxide confinement layer during driving and/or mounting.

For example, in the surface-emitting element described in Patent Document 2, the oxidized region of the oxide confinement layer is generally tapered, and it is possible to generally alleviate stress applied during driving and/or mounting. In the surface-emitting element, however, since the taper is relatively gentle, the alleviation of the stress becomes insufficient depending on magnitude of the stress applied during driving and/or mounting, and there is a possibility that cracks occur in the element. That is, in the surface-emitting element, there is room for improvement in terms of suppressing occurrence of cracks due to an oxide confinement layer during driving and/or mounting.

Therefore, as a result of intensive studies, the inventors have developed a surface-emitting element according to the present technology as a surface-emitting element capable of suppressing occurrence of cracks due to an oxide confinement layer during driving and/or mounting by devising a shape of an oxidized region of the oxide confinement layer. The ability to suppress the occurrence of cracks leads to improvement in electro-optical characteristics and reliability.

In particular, even in a case where the surface-emitting element according to the present technology is employed in a surface-emitting element of a back surface emission type that is directly connected to a substrate (for example, a driver) by junction-down mounting (flip-chip mounting) and in which a large force is applied to the element, it is possible to effectively suppress occurrence of cracks and to achieve a surface-emitting element of the back surface emission type having high electro-optical characteristics and reliability. Even in a case where the surface-emitting element according to the present technology is employed in a front surface emission type, it is possible to effectively suppress occurrence of cracks and to achieve a front surface emission type surface-emitting element having high electro-optical characteristics and reliability.

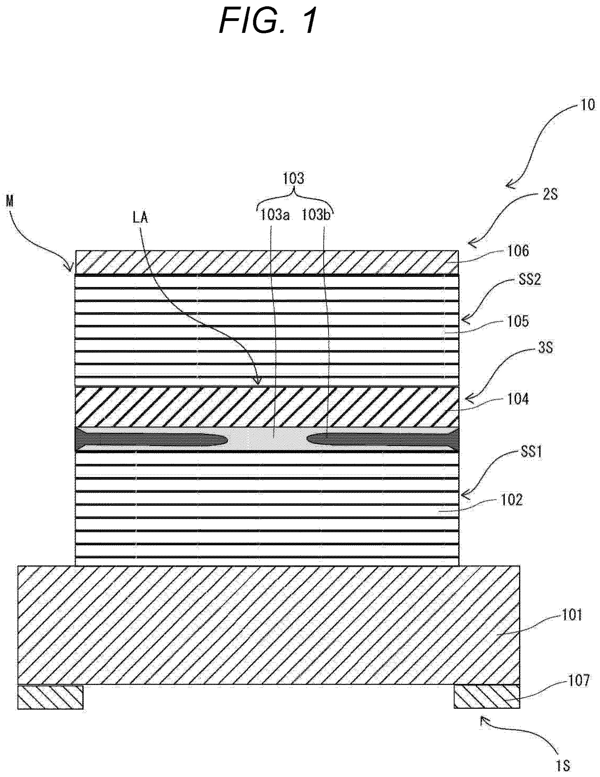

Some example of an embodiment of the surface-emitting element according to the present technology will be described in detail hereinafter. In cross-sectional views of Fig. 1 and other drawings, an upper side will be referred to as "upper" and a lower side will be referred to as "lower" as appropriate hereinafter.

<1. Surface-Emitting Element According to Example 1 of Embodiment of Present Technology>

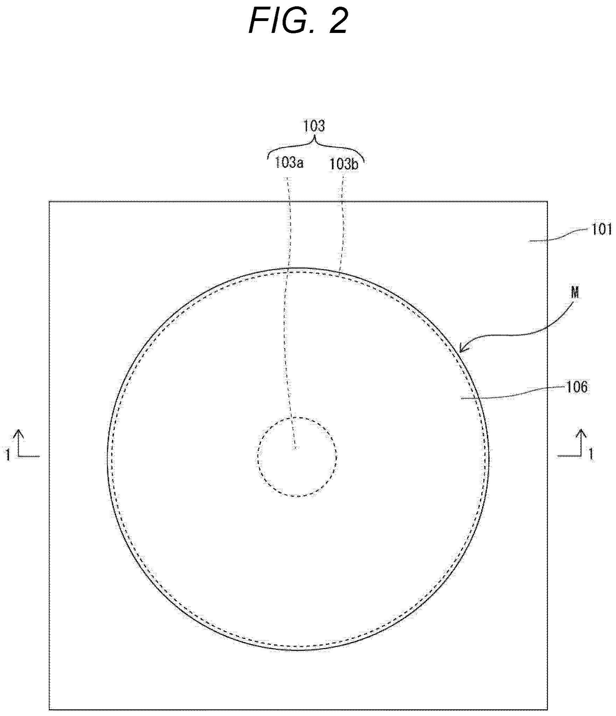

Fig. 1 is a cross-sectional view of a surface-emitting element 10 according to Example 1 of the embodiment of the present technology. Fig. 2 is a plan view of the surface-emitting element 10 according to Example 1 of the embodiment of the present technology. Fig. 1 is a cross-sectional view taken along line 1-1 in Fig. 2.

<<Configuration of Surface-Emitting Element>>

(Overall Configuration)

As an example, as illustrated in Figs. 1 and 2, the surface-emitting element 10 according to the present technology is a vertical cavity surface-emitting laser (VCSEL). The surface-emitting element 10 is, for example, a VCSEL of the back surface emission type.

The surface-emitting element 10 is driven by a driver as an example. As an example, the driver includes a power supply and a transistor that controls on and off of energization from the power supply to the surface-emitting element 10.

As an example, the surface-emitting element 10 has a first structure 1S including a first semiconductor structure SS1, a second structure 2S stacked with the first structure 1S and including a second semiconductor structure SS2, and a third structure 3S arranged between the first and second structures S1 and S2 and including a light-emitting layer 104. As an example, an oxide confinement layer 103 is provided between a surface (lower surface) of the first structure 1S opposite the light-emitting layer 104 side and the light-emitting layer 104.

As an example, the first structure 1S further includes a substrate 101 disposed on a side of the first semiconductor structure SS1 opposite the light-emitting layer 104. The surface-emitting element 10 emits laser light to the side of the first structure 1S opposite the light-emitting layer 104 (back surface side (lower surface side) of the substrate 101). A direction (vertical direction) in which the first and second structures 1S and 2S are stacked will also be referred to as a "stacking direction" hereinafter.

As an example, the first semiconductor structure SS1 includes a first semiconductor multilayer mirror 102.

As an example, the oxide confinement layer 103 is arranged between the first semiconductor multilayer mirror 102 and the light-emitting layer 104. The oxide confinement layer 103 sets a light-emitting region LA of the light-emitting layer 104. The light-emitting region LA is a region (current injection region) of the light-emitting layer 104 into which a current is injected and is a region that emits light.

As an example, the second semiconductor structure SS2 includes a second semiconductor multilayer mirror 105. As an example, the second semiconductor multilayer mirror 105 is different in conductivity type from the first semiconductor multilayer mirror 102.

That is, in the surface-emitting element 10, as an example, the first semiconductor multilayer mirror 102, the oxide confinement layer 103, the light-emitting layer 104, and the second semiconductor multilayer mirror 105 are stacked on the substrate 101 in this order.

In the surface-emitting element 10, the light-emitting layer 104 has a double heterostructure sandwiched, in a stacking direction, between the first and second semiconductor multilayer mirrors 102 and 105 having different conductivity types, and holes and electrons can undergo radiative recombination in the light-emitting layer 104.

In the surface-emitting element 10, a resonator is configured by including the light-emitting layer 104 and the first and second semiconductor multilayer mirrors 102 and 105 sandwiching the light-emitting layer 104 in the stacking direction.

As an example, a mesa M is configured by including at least a part of the first semiconductor structure SS1 (for example, the first semiconductor multilayer mirror 102), the light-emitting layer 104, and the second semiconductor structure SS2 (for example, the second semiconductor multilayer mirror 105). Here, a planar shape of the mesa M is a circle (see Fig. 2), but may be a polygon such as an ellipse, a square, a rectangle, a hexagon, or an octagon, instead.

As an example, a cathode electrode 106 (n-side electrode) is provided at a top of the mesa M as a blanket layer.

As an example, an anode electrode 107 (p-side electrode) is provided on a back surface (lower surface) of the substrate 101 in such a way as to surround the light-emitting region LA of the light-emitting layer 104 in plan view.

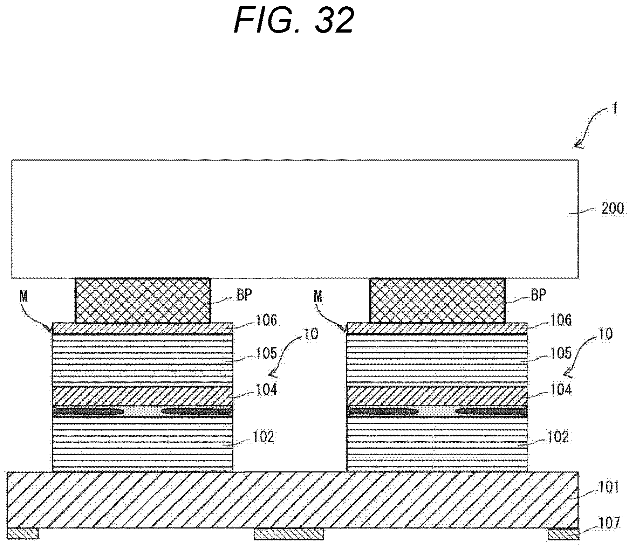

As an example, as illustrated in Fig. 32, the surface-emitting element 10 is mounted on another substrate 200 (for example, a driver, a wiring board, or the like) by junction down. That is, in the surface-emitting element 10, as an example, cathode electrodes 106 provided at tops of mesas M are bonded to the another substrate 200 via bumps BP.

(Substrate)

As an example, the substrate 101 includes a GaAs substrate (for example, a p-GaAs substrate).

(First Semiconductor Multilayer Mirror)

As an example, the first semiconductor multilayer mirror 102 is a semiconductor multilayer mirror doped with a p-type impurity, has little light absorption, and has high reflectance and conductivity. The semiconductor multilayer mirror has a structure in which a plurality of types (for example, two types) of semiconductor layers (for example, AlGaAs layers) having different refractive indices is alternately stacked with an optical thickness that is 1/4 of an emission wavelength. Examples of the p-type impurity (p-type dopant) include Zn, Mg, Be, and C.

(Light-Emitting Layer)

As an example, the light-emitting layer 104 includes a compound semiconductor having band gap energy smaller than those of the first and second semiconductor structures SS1 and SS2. The light-emitting layer 104 includes, for example, a GaAs-based compound semiconductor (for example, GaAs, AlGaAs, GaInAs, GaInAsN, or the like). The light-emitting layer 104 may have a quantum well structure, a multiple quantum well structure, or a quantum dot structure. The light-emitting layer 104 is also called an "active layer".

(Second Semiconductor Multilayer Mirror)

As an example, the second semiconductor multilayer mirror 105 is a semiconductor multilayer mirror doped with an n-type impurity, has little light absorption, and has high reflectance and conductivity. The semiconductor multilayer mirror has a structure in which a plurality of types (for example, two types) of semiconductor layers (for example, AlGaAs layers) having different refractive indices is alternately stacked with an optical thickness that is 1/4 of an emission wavelength. Examples of the n-type impurity (n-type dopant) include Si, Se, and Ge. The second semiconductor multilayer mirror 105 is set slightly higher in reflectance than the first semiconductor multilayer mirror 102.

(Anode Electrode)

The anode electrode 107 is, for example, Au/Pt/Ti or the like. The anode electrode 107 is connected to an anode side of the driver.

(Cathode Electrode)

The cathode electrode 106 is, for example, Au/Ni/AuGe or the like. The cathode electrode 106 is connected to a cathode side of the driver.

(Oxide Confinement Layer)

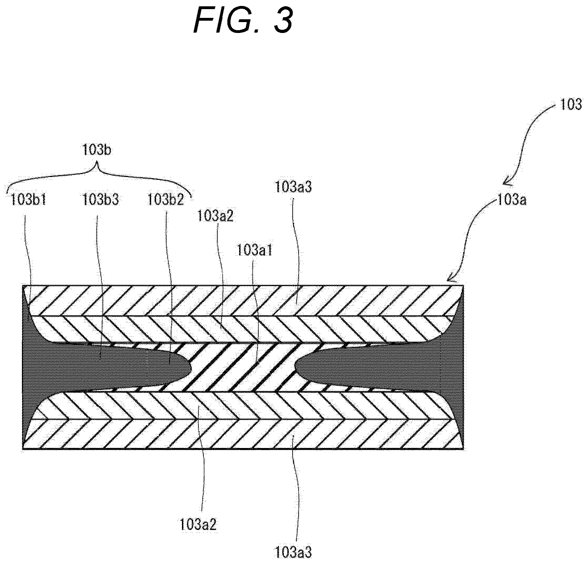

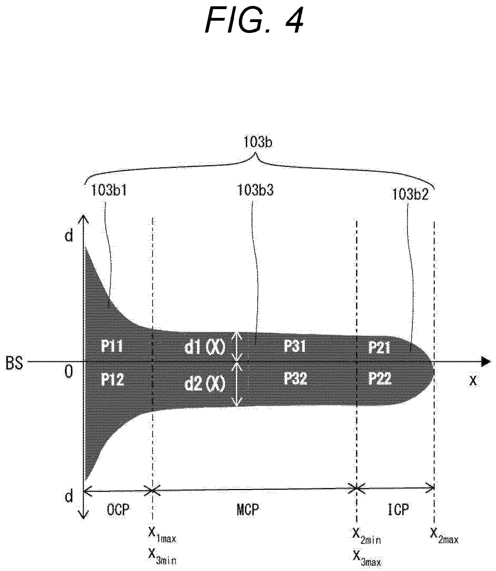

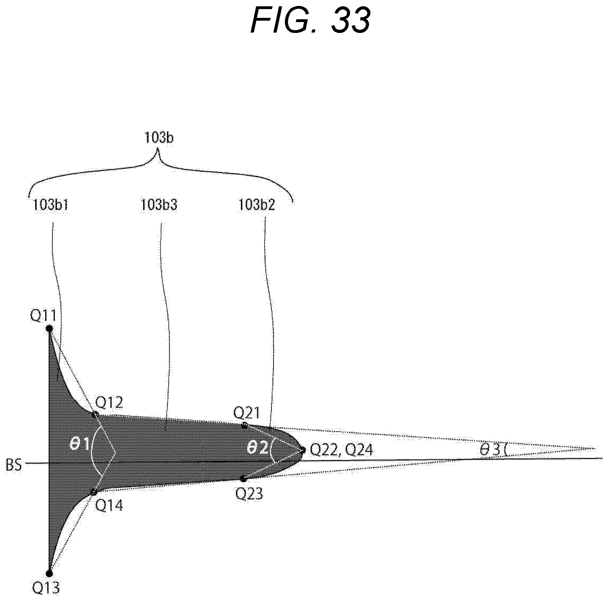

Fig. 3 is a cross-sectional view of the oxide confinement layer 103 of the surface-emitting element 10. Fig. 4 is a diagram for explaining an oxidized region 103b of the oxide confinement layer 103 of the surface-emitting element 10.
The oxide confinement layer 103 includes a non-oxidized region 103a and the oxidized region 103b surrounding at least a part of the non-oxidized region 103a. As an example, the non-oxidized region 103a has a multilayer structure in which a plurality of (for example, five) semiconductor layers including a compound semiconductor (for example, a GaAs-based compound semiconductor) is stacked. The oxidized region 103b includes an insulator (for example, an oxide such as $Al_xO_y$). The oxide confinement layer 103 is preferably disposed at a position of a node of a standing wave generated in the resonator or in the vicinity thereof.
As illustrated in Fig. 3, the oxidized region 103b of the oxide confinement layer 103 has a plurality of tapered portions whose thickness decreases toward inner peripheral ends. Each of the tapered portions may have flat surfaces or curved surfaces as one surface and another surface facing each other in a thickness direction, or may have a flat surface on one side and a curved surface on another side. Here, the plurality of tapered portions is three tapered portions (for example, first to third tapered portions 103b1, 103b2, and 103b3). Each of the tapered portions has a circumferential shape in plan view.
More specifically, the oxidized region 103b surrounds an axis passing through the center of the non-oxidized region 103a and extending in the stacking direction of the first and second structures 1S and 2S, and the thickness of each tapered portion decreases toward the axis.
The first to third tapered portions 103b1, 103b2, and 103b3 are located at different positions in a radial direction of the oxidized region 103b.
The oxidized region 103b has the first tapered portion 103b1 as a tapered portion on an outer peripheral portion OCP (an outermost peripheral portion, see Fig. 4).
The oxidized region 103b has the second tapered portion 103b2 as a tapered portion on an inner peripheral portion ICP (an innermost peripheral portion, see Fig. 4).
In the oxide confinement layer 103, since the oxidized region 103b has a higher resistance and a lower refractive index than those of the non-oxidized region 103a, a region of the non-oxidized region 103a surrounded by the second tapered portion 103b2 functions as a current/light passing region, and the oxidized region 103b functions as a current/light confinement region.
A taper angle θ1 (an angle indicating a degree of spread of the entirety of the first tapered portion 103b1, see Fig. 33) of the first tapered portion 103b1 is preferably larger than a taper angle θ2 (an angle indicating a degree of spread of the entirety of the second tapered portion 103b2, see Fig. 33) of the second tapered portion 103b2. This is because stress is more likely to concentrate in the outer peripheral portion OCP than in the inner peripheral portion ICP during driving and/or mounting.

The oxidized region 103b has a middle peripheral portion MCP (see Fig. 4) between the outer peripheral portion OCP and the inner peripheral portion ICP, and the middle peripheral portion MCP has the third tapered portion 103b3 as a tapered portion. A taper angle $\theta3$ (an angle indicating a degree of spread of the entirety of the third tapered portion 103b3, see Fig. 33) of the third tapered portion 103b3 is preferably smaller than the taper angle of the second tapered portion 103b2. This is because stress is more likely to concentrate in the inner peripheral portion ICP than in the middle peripheral portion MCP during driving and/or mounting.

Fig. 33 is a diagram illustrating one side portion of the oxidized region 103b of Fig. 3 in an extracted manner, and is a diagram for explaining the taper angle of each tapered portion. As illustrated in Fig. 33, a plane that is located at an arbitrary position in the thickness direction of the oxide confinement layer 103 and that is parallel to an in-plane direction is defined as a reference plane BS. In a cross section of the oxidized region 103b illustrated in Fig. 33, an angle $81$ ($< \pi$) between a straight line passing through an outer peripheral end Q11 and an inner peripheral end Q12 on one side (for example, an upper side) of the reference plane BS of the first tapered portion 103b1 and a straight line passing through an outer peripheral end Q13 and an inner peripheral end Q14 on another side (for example, a lower side) of the reference plane BS of the first tapered portion 103b1 can be defined as the taper angle of the first tapered portion 103b1.

In the cross section of the oxidized region 103b illustrated in Fig. 33, an angle $\theta2$ ($< \pi$) between a straight line passing through an outer peripheral end Q21 and an inner peripheral end Q22 on one side (for example, the upper side) of the reference plane BS of the second tapered portion 103b2 and a straight line passing through an outer peripheral end Q23 and an inner peripheral end Q24 (coincides with Q22 here) on another side (for example, the lower side) of the reference plane BS of the second tapered portion 103b2 can be defined as the taper angle of the second tapered portion 103b2.

In the cross section of the oxidized region 103b illustrated in Fig. 33, an angle $\theta3$ ($< \pi$) between a straight line passing through the outer peripheral end Q12 and the inner peripheral end Q21 on one side (for example, the upper side) of the reference plane BS of the third tapered portion 103b3 and a straight line passing through the outer peripheral end Q14 and the inner peripheral end Q23 on another side (for example, the lower side) of the reference plane BS of the third tapered portion 103b3 can be defined as the taper angle of the third tapered portion 103b3.

Here, as illustrated in Fig. 4, a plane that is located at an arbitrary position in the thickness direction of the oxide confinement layer 103 and that is parallel to the in-plane direction is defined as a reference plane BS. An x-axis is set in a direction from the outer peripheral end (x = 0) of the oxidized region 103b toward the inner peripheral end along the reference plane BS. A range of the outer peripheral portion OCP in the x-axis direction is defined as $0 \leq x \leq x_{1max}$ (0: an x-coordinate of the outer peripheral end of the outer peripheral portion OCP, $x_{1max}$: an x-coordinate of the inner peripheral end of the outer peripheral portion OCP), a range of the middle peripheral portion MCP in the x-axis direction is defined as $x_{3min} \leq x \leq x_{3max}$ ($x_{3min}$: an x-coordinate of the outer peripheral end of the middle peripheral portion MCP, $x_{3max}$: an x-coordinate of the inner peripheral end of the middle peripheral portion MCP), and a range of the inner peripheral portion ICP in the x-axis direction is defined as $x_{2min} \leq X \leq x_{2max}$ ($x_{2min}$: an x-coordinate of the outer peripheral end of the inner peripheral portion ICP, $x_{2max}$: an x-coordinate of the inner peripheral end of the inner peripheral portion ICP). In this case, the following Expression (1) is preferably satisfied. Here, $x_{1max} = x_{3min}$ and $x_{3max} = x_{2min}$.

$$x_{2max} - x_{3max} = 1 \ \mu m \ \text{and/or} \ x_{1max} = 1 \ \mu m \quad (1)$$

Note that $x_{2max} - x_{2min} > x_{1max}$ may be satisfied, or $x_{2max} - x_{2min} < x_{1max}$ may be satisfied.

Although $x_{3max} - x_{3min} > x_{1max}$ is satisfied here, $x_{3max} - x_{3min} \leq x_{1max}$ may be satisfied, instead.

Although $x_{3max} - x_{3min} > x_{2max} > x_{2min}$ is satisfied here, $x_{3max} - x_{3min} \leq x_{2max} - x_{2min}$ may be satisfied, instead.

The following Expressions (2) and/or (3) are preferably satisfied, where, as illustrated in Fig. 4, a thickness of a first portion P11 for each x-coordinate and a thickness of a second portion P12 for each x-coordinate in a case where a portion of the first tapered portion 103b1 on one side (for example, the upper side) of the reference plane BS is defined as the first portion P11, and a portion on another side (for example, the lower side) is defined as the portion P12 are denoted by d1(x) and d2(x), respectively, and $x_{11} < x_{12} < \cdots < x_{1n}$ (n is a natural number).

$$d1(x_{11}) > d1(x_{12}) > \cdots > d1(x_{1n}) \quad (2)$$

$$d2(x_{11}) > d2(x_{12}) > \cdots > d2(x_{1n}) \quad (3)$$

The satisfaction of Expressions (2) and (3) described above means that both the thicknesses d1(x) and d2(x) of the first and second portions P11 and P12 of the first tapered portion 103b1 monotonically decrease with an increase in x.

The following Expression (4) is preferably satisfied, where, as illustrated in Fig. 4, the thickness of a first portion P11 for each x-coordinate and the thickness of a second portion P12 for each x-coordinate in a case where the portion of the first tapered portion 103b1 on one side (for example, the upper side) of the reference plane BS is defined as the first portion P11, and the portion on another side (for example, the lower side) is defined as the second portion P12 are denoted by d1(x) and d2(x), respectively.

$$[\{d1(0) + d2(0)\} - \{d1(x_{1max}) + d2(x_{1max})\}]/x_{1max} \geq 0.05 \tag{4}$$

The above Expression (4) indicates that the taper angle (degree of spread) of the first tapered portion 103b1 essentially increases steeply.

For example, in a case where $x_{1max} = 1 \mu m$, if

$$[\{d1(0) + d2(0)\} - \{d1(x_{1max}) + d2(x_{1max})\}] \geq 50 \text{ nm,}$$

the above Expression (4) is satisfied. Note that the numerical value on the right side of the above Expression (4) may be, for example, any of 0.2, 0.3, 0.4, and 0.5, instead of 0.1.

The following Expression (5) is preferably satisfied, where, as illustrated in Fig. 4, a thickness of a first portion P21 for each x-coordinate and a thickness of a second portion P22 for each x-coordinate in a case where a portion of the second tapered portion 103b2 on one side (for example, the upper side) of the reference plane BS is defined as the first portion P21 and a portion on another side (for example, the lower side) is defined as the second portion P22 are denoted by d1(x) and d2(x), respectively, and $x_{21} < x_{22} < \cdots < x_{2n}$ (n is a natural number).

$$(d1(x_{21}) + d2(x_{21})) > (d1(x_{22}) + d2(x_{22})) > \cdots > (d1(x_{2n}) + d2(x_{2n}))$$

The satisfaction of the above Expression (5) means that the thickness [d1(x) + d2(x)] of the second tapered portion 103b2 monotonically decreases with an increase in x.

The following Expression (6) is preferably satisfied, where, as illustrated in Fig. 4, a thickness of a first portion P31 for each x-coordinate and a thickness of a second portion P32 for each x-coordinate in a case where a portion of the third tapered portion 103b3 on one side (for example, the upper side) of the reference plane BS is defined as the first portion P31 and a portion on another side (for example, the lower side) is defined as the second portion P32 are denoted by d1(x) and d2(x), respectively, and $x_{31} < x_{32} < \cdots < x_{3n}$ (n is a natural number).

$$(d1(x_{31}) + d2(x_{31})) > (d1(x_{32}) + d2(x_{32})) > \cdots > (d1(x_{3n}) + d2(x_{3n}))$$

The satisfaction of the above Expression (6) means that the thickness [d1(x) + d2(x)] of the third tapered portion 103b3 monotonically decreases with an increase in x.

The following Expression (7) is preferably satisfied, where, as illustrated in Fig. 4, the x-coordinate of the outer peripheral end of the third tapered portion 103b3 is represented by $x_{3min}$ and the x-coordinate of the inner peripheral end of the third tapered portion 103b3 is represented by $x_{3max}$.

$$[\{d1(x_{3min}) + d2(x_{3min})\} - \{d1(x_{3max}) + d2(x_{3max})\}]/(x_{3max} - x_{3min}) \leq 0.01 \tag{7}$$

The above Expression (7) indicates that the taper angle (degree of spread) of the third tapered portion 103b3 essentially increases gradually.

For example, in a case where $x_{3max} = 5 \mu m$, if

$$[\{d1(x_{3min}) + d2(x_{3min})\} - \{d1(x_{3max}) + d2(x_{3max})\}] \leq 50 \text{ nm,}$$

the above Expression (7) is satisfied. Note that the numerical value on the right side of the above Expression (7) may be, for example, any of 0.007, 0.005, and 0.003, instead of 0.01.

As an example, at least one of the plurality of tapered portions (for example, one of the first to third tapered portions 103b1, 103b2, and 103b3) is not parallel to the in-plane direction on both of the one surface and the another surface facing each other in the thickness direction. Here, inclination angles of the one surface and the another surface with respect to the in-plane direction are the same. That is, each tapered portion has a vertically symmetrical shape as an example.

Returning to Fig. 3, the non-oxidized region 103a has, as an example, a multilayer structure in which a plurality of (for example, five) semiconductor layers (for example, one semiconductor layer 103a1, two semiconductor layers 103a2, and two semiconductor layers 103a3) having different Al compositions is stacked. Each semiconductor layer includes, for example, AlGaAs, AlAs, or the like.

In the multilayer structure, the Al composition of the semiconductor layer at a predetermined position in a stacking direction of the first and second structures 1S and 2S is the highest, and the Al composition of a semiconductor layer closer to the semiconductor layer at the predetermined position is higher.

More specifically, among the five semiconductor layers, the Al composition of the semiconductor layer 103a1 located at the center in the stacking direction is the highest, and the Al compositions of the semiconductor layers 103a3 and 103a3 located at one end and another end in the stacking direction are the lowest.

The semiconductor layer 103a1 is, for example, an AlAs layer. The semiconductor layers 103a2 include, for example, $Al_\alpha GaAs$. The semiconductor layers 103a3 include, for example, $Al_\beta GaAs$ $(0 < \beta < \alpha < 1)$. Here, as an example, the first tapered portion 103b1 is provided in such a way as to straddle the three semiconductor layers 103a1, 103a2, and 103a3, and the second and third tapered portions 103b2 and 103b3 are provided at least in the semiconductor layer 103a1.

Here, the thickness of the plurality of (for example, five) semiconductor layers constituting the multilayer structure of the non-oxidized region 103a is the greatest in the semiconductor layer located at the center in the stacking direction, but is not limited thereto, and can be appropriately changed.

<<Operation of Surface-Emitting Element>>

The operation of the surface-emitting element 10 will be described hereinafter. When a power supply voltage of the driver is applied to the surface-emitting element 10, a current from the anode side of the driver is narrowed by the oxide confinement layer 103 and injected into the light-emitting region LA of the light-emitting layer 104 through the anode electrode 107, the substrate 101, and the first semiconductor multilayer mirror 102 in this order. At this time, the light-emitting region LA emits light, and the light travels between the first and second semiconductor multilayer mirrors 102 and 105 while being confined by the oxide confinement layer 103 and amplified by the light-emitting layer 104, and is emitted as laser light from the back surface side of the substrate 101 when an oscillation condition is satisfied. The current injected into the light-emitting region LA flows out to the cathode side of the driver through the second semiconductor multilayer mirror 105 and the cathode electrode 106 in this order. In the surface-emitting element 10, concentration of stress on a part of the oxide confinement layer 103 is suppressed during driving, and occurrence of cracks is effectively suppressed.

<<Method for Manufacturing Surface-Emitting Element>>

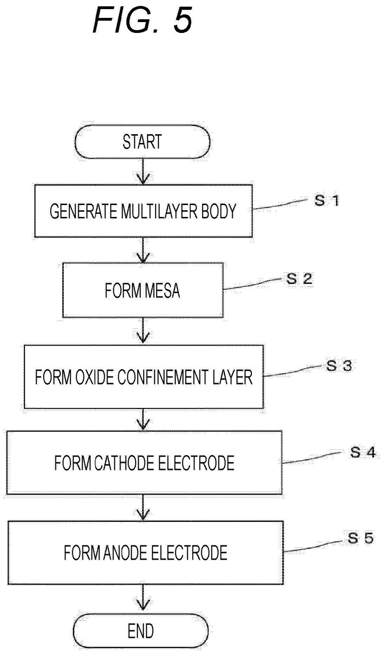

An example of a method for manufacturing the surface-emitting element 10 will be described hereinafter with reference to a flowchart of Fig. 5 and the like. As an overall flow, first, a plurality of surface-emitting elements 10 is simultaneously generated on one wafer (hereinafter referred to as a "substrate 101" for convenience), which is a base material of the substrate 101, by a semiconductor manufacturing method using a semiconductor manufacturing apparatus. Next, the plurality of continuous integrated surface-emitting elements 10 is separated from each other by dicing to obtain chip-shaped surface-emitting elements 10.

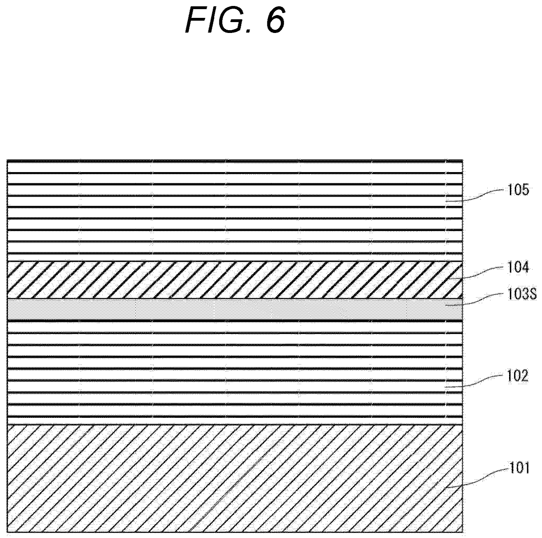

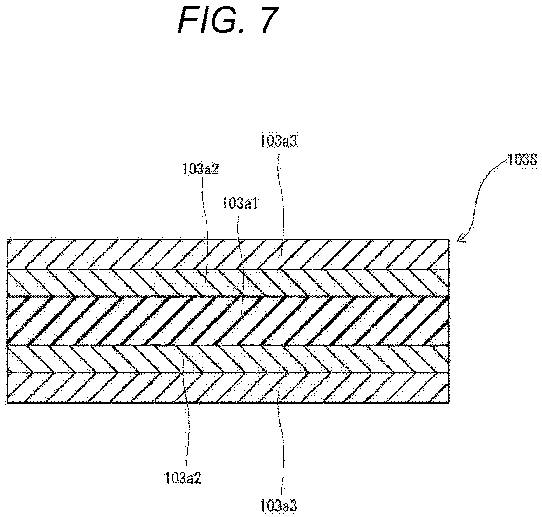

In the first step S1, a multilayer body is generated (see Fig. 6). Specifically, for example, the first semiconductor multilayer mirror 102, an oxidation layer 103S (see Fig. 7; a layer having a multilayer structure in which five semiconductor layers having different Al compositions similar to those of the non-oxidized region 103a of Fig. 3 are stacked), the light-emitting layer 104, and the second semiconductor multilayer mirror 105 are stacked in this order on the substrate 101 as a growth substrate by an epitaxial crystal growth method such as a metal organic chemical vapor deposition (MOCVD) method to generate a multilayer body. At this time, as raw materials of the compound semiconductor, for example, a methyl-based organometallic gas such as trimethylaluminum (TMAl), trimethylgallium (TMGa), or trimethylindium (TMIn) and an arsine $(AsH_3)$ gas are used, as a raw material of donor impurities, for example, disilane $(Si_2H_6)$ is used, and as a raw material of acceptor impurities, for example, carbon tetrabromide $(CBr_4)$ is used.

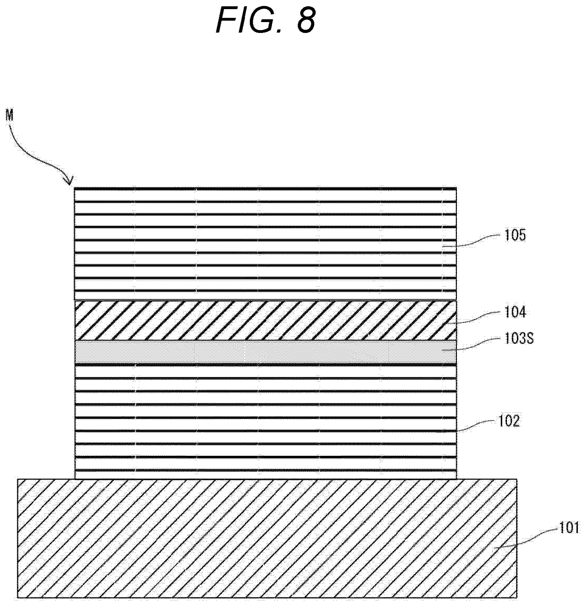

In the next step S2, a mesa M is formed (see Fig. 8). Specifically, a resist pattern covering a portion where the mesa M is to be formed is formed on the multilayer body by photolithography, and the multilayer body is etched by dry etching or wet etching using the resist pattern as a mask. The etching is performed here as deeply as, for example, the substrate 101 is exposed. Thereafter, the resist pattern is removed.

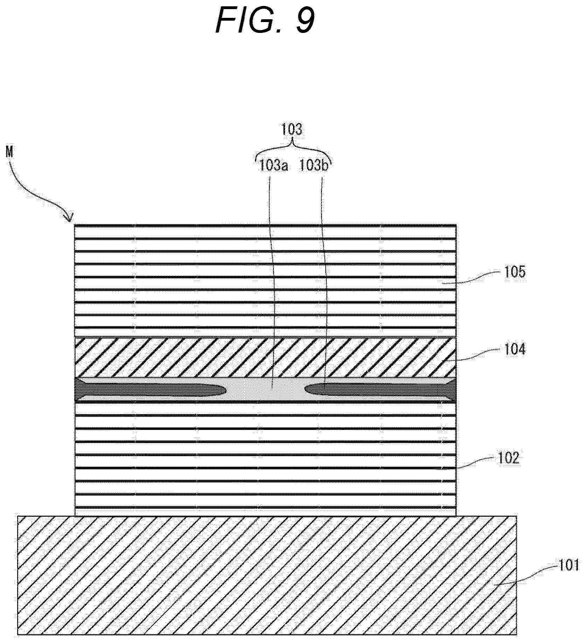

In the next step S3, the oxide confinement layer 103 is formed (see Fig. 9). Specifically, the mesa M (see Fig. 8) is exposed to a high-temperature water vapor atmosphere, and the oxidation layer 103S is selectively oxidized by a predetermined distance from a side surface to form the oxide confinement layer 103. Here, among the five semiconductor layers constituting the oxidation layer 103S, the semiconductor layer 103a1 (the semiconductor layer having the highest Al composition; see Fig. 7) located at the center in the stacking direction has the highest oxidation rate, and the semiconductor layers 103a3 (the semiconductor layers having the lowest Al compositions; see Fig. 7) located at one end and another end in the stacking direction has the lowest oxidation rate. Therefore, the oxide confinement layer 103 has, for example, a shape in which the oxidized region 103b has two tapered portions in which the thickness decreases toward oxidation terminals from oxidation start ends (outer peripheral ends) to the oxidation terminals (inner peripheral ends) as illustrated in Fig. 3. As is clear from the above description, the oxidation rate can be controlled by the Al compositions of the plurality of semiconductor layers constituting the oxidation layer 103S, and the shape of the oxidized region 103b can be controlled. Since the oxidation rate also depends on the thickness of each semiconductor layer of the oxidation layer 103S, the shape of the oxidized region 103b can also be controlled by adjusting the thickness of the semiconductor layer. That is, the shape of the oxidized region 103b can be controlled by adjusting the Al composition and/or the thickness of each semiconductor layer of the oxidation layer 103S. Furthermore, the shape of the oxidized region 103b can also be controlled by oxidation conditions and the like.

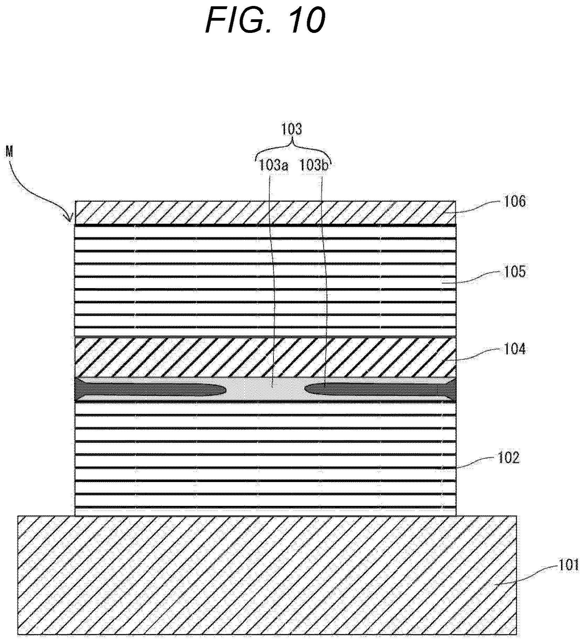

In the next step S4, the cathode electrode 106 is formed (see Fig. 10). Specifically, for example, the cathode electrode 106 is formed as a blanket layer on the top of the mesa M by a lift-off method. At this time, for example, vapor deposition, sputtering, or the like is used to form the electrode material.

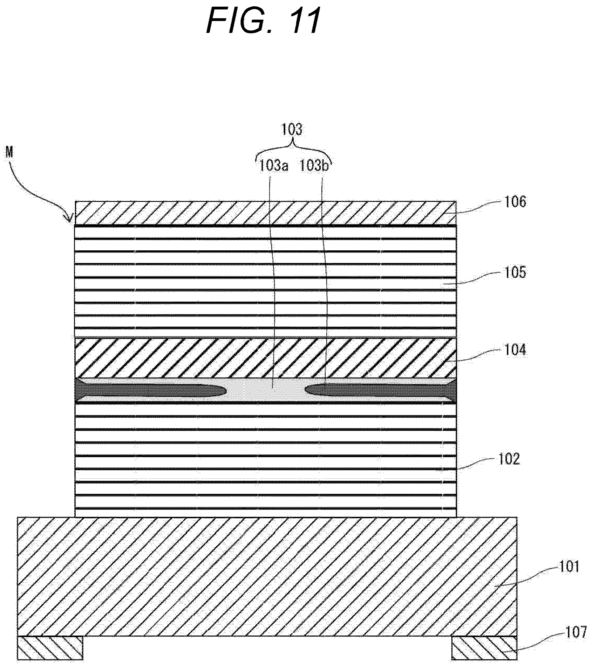

In the final step S5, the anode electrode 107 is formed (see Fig. 11). Specifically, the anode electrode 107 is formed on the back surface of the substrate 101 in such a way as to surround the light-emitting region by, for example, a lift-off method.

<<Effects of surface-emitting Element>>

Effects of the surface-emitting element 10 will be described hereinafter.

The surface-emitting element 10 has the first structure 1S including the first semiconductor structure SS1, the second structure S2 stacked with the first structure 1S and including the second semiconductor structure SS2, and the third structure S3 arranged between the first and second structures S1 and S2 and including the light-emitting layer 104. The oxide confinement layer 103 is provided between the surface of the first structure S1 opposite the light-emitting layer 104 side and the light-emitting layer 104. The oxide confinement layer 103 includes the non-oxidized region 103a and the oxidized region 103b surrounding at least a part of the non-oxidized region 103a. The oxidized region 103b has a plurality of tapered portions whose thickness decreases toward inner peripheral ends.

In the surface-emitting element 10, since the oxidized region 103b of the oxide confinement layer 103 has the plurality of tapered portions, it is possible to effectively suppress concentration of stress on a portion where each tapered portion is provided during driving and/or mounting.

With the surface-emitting element 10, it is possible to achieve a surface-emitting element (for example, a surface-emitting laser) capable of suppressing occurrence of cracks due to the oxide confinement layer 103 during driving and/or mounting.

On the other hand, in the conventional surface-emitting elements, since the oxidized region of the oxide confinement layer has a single tapered portion or has a gradually tapered shape as the entire oxidized region, it is difficult to effectively suppress stress concentration in the oxidized region.

The plurality of tapered portions is located at different positions in the radial direction of the oxidized region 103b. This makes it possible to suppress concentration of stress at different positions in the radial direction.

The oxidized region 103b has the first tapered portion 103b1 as a tapered portion in the outer peripheral portion OCP. As a result, it is possible to suppress concentration of stress in the outer peripheral portion OCP, and it is possible to suppress occurrence of cracks due to the outer peripheral portion OCP.

The oxidized region 103b has the second tapered portion 103b2 as a tapered portion in the inner peripheral portion ICP. As a result, it is possible to suppress concentration of stress in the inner peripheral portion ICP, and it is possible to suppress occurrence of cracks due to the inner peripheral portion ICP. Furthermore, it is also possible to suppress deterioration of the inner peripheral portion ICP due to concentration of current density.

The taper angle of the first tapered portion 103b1 is preferably larger than the taper angle of the second tapered portion 103b2.

The oxidized region 103b preferably has the middle peripheral portion MCP between the outer peripheral portion OCP and the inner peripheral portion ICP.

The middle peripheral portion MCP may have the third tapered portion 103b3 as a tapered portion.

At least one of the plurality of tapered portions is not parallel to the in-plane direction on both of the one surface and the another surface facing each other in the thickness direction.

The non-oxidized region 103a has a multilayer structure in which a plurality of semiconductor layers having different Al compositions is stacked, and in the multilayer structure, the Al composition of the semiconductor layer at the predetermined position in the stacking direction of the first and second structures is the highest, and the Al composition of a semiconductor layer closer to the semiconductor layer at the predetermined position is higher. As a result, the oxide confinement layer 103 having the oxidized region 103b having the plurality of tapered portions can be efficiently formed at low cost by a selective oxidation process.

Some modifications of the embodiment of the present technology will be described hereinafter.

<1.5. Surface-Emitting Elements According to Modifications 1 to 8 of Example 1 of Embodiment of Present Technology>

(Surface-Emitting Element According to Modification 1 of Example 1 of Embodiment of Present Technology)

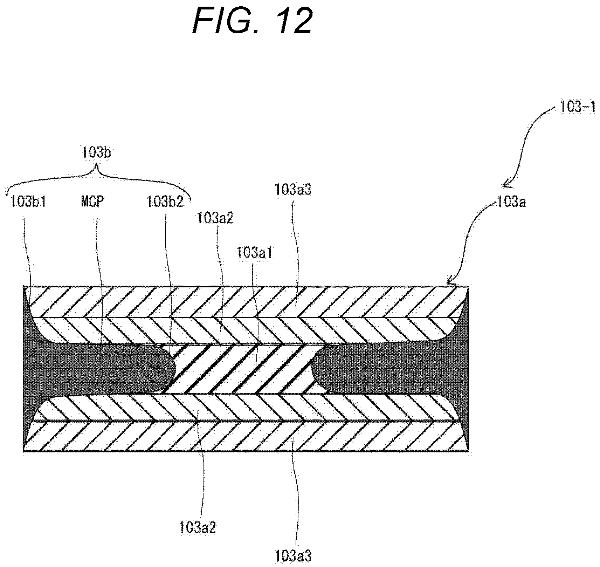

Fig. 12 is a cross-sectional view of an oxide confinement layer 103-1 of a surface-emitting element according to Modification 1 of Example 1 of the embodiment of the present technology.

As illustrated in Fig. 12, the surface-emitting element according to Modification 1 has a similar configuration to that of the surface-emitting element 10 according to Example 1 except that the thickness of the middle peripheral portion MCP of the oxidized region 103b of the oxide confinement layer 103-1 is constant.

In the oxide confinement layer 103-1, each of the first and second tapered portions 103b1 and 103b2 is not parallel to the in-plane direction on both of one surface and another surface facing each other in the thickness direction. Here, each tapered portion of the oxidized region 103b has a vertically symmetrical shape.

In the oxide confinement layer 103-1, as in the example of Fig. 4, in a case where a portion of the middle peripheral portion MCP on one side of the reference plane BS is defined as a first portion P31, a portion on another side is defined as a second portion P32, an x-axis is set in a direction from an outer peripheral end to an inner peripheral end of the oxidized region 103b along the reference plane BS, a thickness of the first portion P31 for each x-coordinate is denoted by $d_1(x)$, a thickness of the second portion P32 for each x-coordinate is $d_2(x)$, and $x_{31} < x_{32} < \cdots < x_{3n}$, the following Expression (8) is preferably satisfied.

$$[d1(x_{31}) + d2(x_{31})] = [d1(x_{32}) + d2(x_{32})] = \cdots = [d1(x_{3n}) + d2(x_{3n})] \tag{8}$$

The satisfaction of the above Expression (8) means that the thickness of the middle peripheral portion MCP is constant.

Also in the surface-emitting element according to Modification 1, it is preferable that at least one of the above Expressions (1) to (5) is satisfied.

With the surface-emitting element according to Modification 1, effects are obtained generally similar to those of the surface-emitting element 10 according to Example 1.

(Surface-Emitting Element According to Modification 2 of Example 1 of Embodiment of Present Technology)

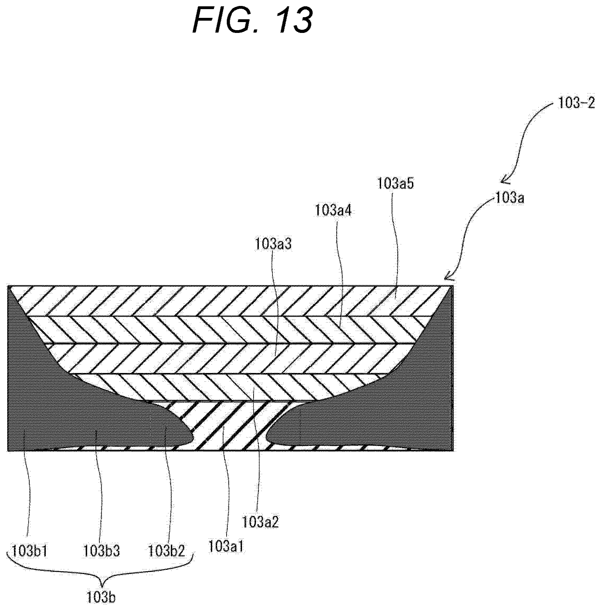

Fig. 13 is a cross-sectional view of an oxide confinement layer 103-2 of a surface-emitting element according to Modification 2 of Example 1 of the embodiment of the present technology.

As illustrated in Fig. 13, the surface-emitting element according to Modification 2 has a similar configuration to that of the surface-emitting element 10 according to Example 1 except that the positions of the second and third tapered portions 103b2 and 103b3 of the oxide confinement layer 103-2 are different.

In the surface-emitting element according to Modification 2, five semiconductor layers 103a1, 103a2, 103a3, 103a4, and 103a5 constituting the multilayer structure of the non-oxidized region 103a are stacked in order of descending Al composition from one end (for example, the lower end) to another end (for example, the upper end) in the stacking direction. That is, in the four semiconductor layers 103a2, 103a3, 103a4, and 103a5, the Al composition is higher as the semiconductor layer is closer to the semiconductor layer 103a1 having the highest Al composition.

The semiconductor layer 103a1 includes, for example, AlAs. The semiconductor layer 103a2 includes, for example, $Al_{\alpha}GaAs$. The semiconductor layer 103a3 includes, for example, $Al_{\beta}GaAs$. The semiconductor layer 103a4 includes, for example, $Al_{\gamma}GaAs$. The semiconductor layer 103a5 includes, for example, $Al_{\delta}GaAs$. Here, $0 < \delta < \gamma < \beta < \alpha < 1$

In the oxide confinement layer 103-2, each of the first to third tapered portions 103b1, 103b2, and 103b3 is not parallel to the in-plane direction on both of one surface and another surface facing each other in the thickness direction. Here, each tapered portion of the oxidized region 103b has a vertically symmetrical shape. Note that the oxide confinement layer 103-2 in Fig. 13 may be turned upside down.

Also in the surface-emitting element according to Modification 2, it is preferable that at least one of the above Expressions (1) to (7) is satisfied. Note that Expression (8) may be satisfied instead of Expression (6), or Expression (8) may be satisfied instead of Expression (7).

With the surface-emitting element according to Modification 2, effects are obtained generally similar to those of the surface-emitting element 10 according to Example 1.

(Surface-Emitting Element According to Modification 3 of Example 1 of Embodiment of Present Technology)

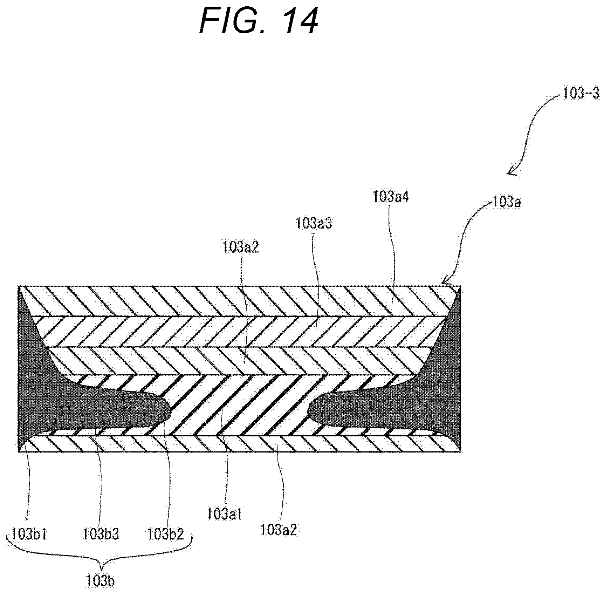

Fig. 14 is a cross-sectional view of an oxide confinement layer 103-3 of a surface-emitting element according to Modification 3 of Example 1 of the embodiment of the present technology.

As illustrated in Fig. 14, the surface-emitting element according to Modification 3 has a similar configuration to that of the surface-emitting element 10 according to Example 1 except that the positions of the second and third tapered portions 103b2 and 103b3 of the oxide confinement layer 103-3 are different.

In the surface-emitting element according to Modification 3, the Al composition of a semiconductor layer 103a1 located at a position (for example, a second position from one end (lower end) in the stacking direction) excluding a position of the one end (for example, the lower end), a position of another end (for example, the upper end), and a central position in the stacking direction among the five semiconductor layers (the semiconductor layer 103a1, two semiconductor layers 103a2, a semiconductor layer 103a3, and a semiconductor layer 103a4) constituting the multilayer structure of the non-oxidized region 103a is the highest. The Al composition of the two semiconductor layers 103a2 adjacent to the semiconductor layer 103a1 is the second highest, the Al composition of the semiconductor layer 103a3 is the third highest, and the Al composition of the semiconductor layer 103a4 is the lowest. Here, a shape of the oxidized region 103b is vertically asymmetric. Note that the oxide confinement layer 103-3 in Fig. 14 may be turned upside down.

The semiconductor layer 103a1 includes, for example, AlAs. Each semiconductor layer 103a2 includes, for example, $Al_\alpha GaAs$. The semiconductor layer 103a3 includes, for example, $Al_\beta GaAs$. The semiconductor layer 103a4 includes, for example, $Al_\gamma GaAs$. Here, $0 < \gamma < \beta < \alpha < 1$

In the oxide confinement layer 103-3, each of the first to third tapered portions 103b1, 103b2, and 103b3 is not parallel to the in-plane direction on both of one surface and another surface facing each other in the thickness direction. Here, each tapered portion of the oxidized region 103b has a vertically symmetrical shape. Note that the oxide confinement layer 103-3 in Fig. 14 may be turned upside down.

Also in the surface-emitting element according to Modification 3, it is preferable that at least one of the above Expressions (1) to (7) is satisfied. Note that Expression (8) may be satisfied instead of Expression (6), or Expression (8) may be satisfied instead of Expression (7).

With the surface-emitting element according to Modification 3, effects are obtained generally similar to those of the surface-emitting element 10 according to Example 1.

(Surface-Emitting Element According to Modification 4 of Example 1 of Embodiment of Present Technology)

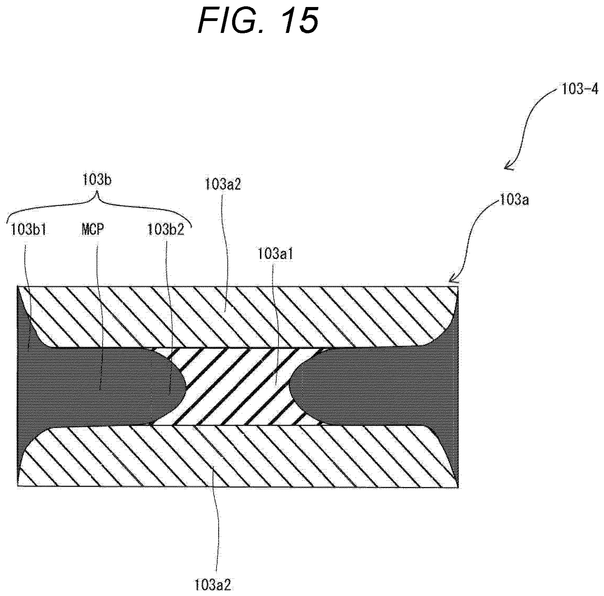

Fig. 15 is a cross-sectional view of an oxide confinement layer 103-4 of a surface-emitting element according to Modification 4 of Example 1 of the embodiment of the present technology.

The surface-emitting element according to Modification 4 has a similar configuration to that of the surface-emitting element according to Example 1 except that a non-oxidized region 103a of the oxide confinement layer 103-4 has a multilayer structure including three semiconductor layers (a semiconductor layer 103a1 and two semiconductor layers 103a2) as illustrated in Fig. 15.

In the surface-emitting element according to Modification 4, the Al composition of the semiconductor layer 103a1 located at the center in the stacking direction among the three semiconductor layers (the semiconductor layer 103a1 and the two semiconductor layers 103a2) constituting the multilayer structure of the non-oxidized region 103a is the highest. The Al compositions of the semiconductor layers 103a2 located at one end and another end in the stacking direction are the same.

The semiconductor layer 103a1 includes, for example, AlAs. Each semiconductor layer 103a2 includes, for example, $Al_\alpha GaAs$. Here, $0 < \alpha < 1$

In the oxide confinement layer 103-4, each of the first and second tapered portions 103b1 and 103b2 is not parallel to the in-plane direction on both of one surface and another surface facing each other in the thickness direction. Here, each tapered portion of the oxidized region 103b has a vertically symmetrical shape.

In the surface-emitting element according to Modification 4, the thickness of the middle peripheral portion MCP is constant, and the above Expression (8) is satisfied.

Also in the surface-emitting element according to Modification 4, it is preferable that at least one of the above Expressions (1) to (5) is satisfied. Note that, instead of the above Expression (8), the above Expression (6) and/or the above Expression (7) may be satisfied.

With the surface-emitting element according to Modification 4, effects are obtained generally similar to those of the surface-emitting element 10 according to Example 1.

(Surface-Emitting Element According to Modification 5 of Example 1 of Embodiment of Present Technology)

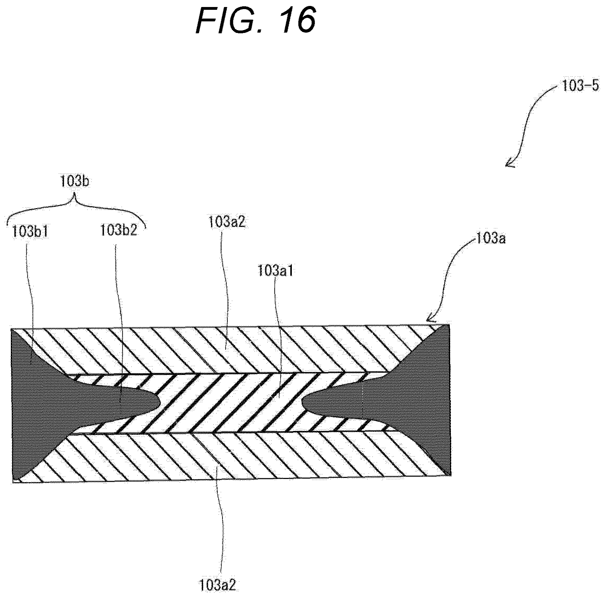

Fig. 16 is a cross-sectional view of an oxide confinement layer 103-5 of a surface-emitting element according to Modification 5 of Example 1 of the embodiment of the present technology.

The surface-emitting element according to Modification 5 has a similar configuration to that of the surface-emitting element according to Example 1 except that a non-oxidized region 103a of the oxide confinement layer 103-5 has a multilayer structure including three semiconductor layers (a semiconductor layer 103a1 and two semiconductor layers 103a2) and the oxidized region 103b does not include the middle peripheral portion MCP as illustrated in Fig. 16.

In the surface-emitting element according to Modification 5, the Al composition of the semiconductor layer 103a1 located at the center in the stacking direction among the three semiconductor layers (the semiconductor layer 103a1 and the two semiconductor layers 103a2) constituting the multilayer structure of the non-oxidized region 103a is the highest. The Al compositions of the semiconductor layers 103a2 located at one end and another end in the stacking direction are the same.

The semiconductor layer 103a1 includes, for example, AlAs. Each semiconductor layer 103a2 includes, for example, $Al_\alpha GaAs$. Here, $0 < \alpha < 1$

In the oxide confinement layer 103-5, each of the first and second tapered portions 103b1 and 103b2 is not parallel to the in-plane direction on both of one surface and another surface facing each other in the thickness direction. Here, each tapered portion of the oxidized region 103b has a vertically symmetrical shape.

Also in the surface-emitting element according to Modification 5, it is preferable that at least one of the above Expressions (2) to (5) is satisfied.

With the surface-emitting element according to Modification 5, effects are obtained generally similar to those of the surface-emitting element 10 according to Example 1.

(Surface-Emitting Element According to Modification 6 of Example 1 of Embodiment of Present Technology)

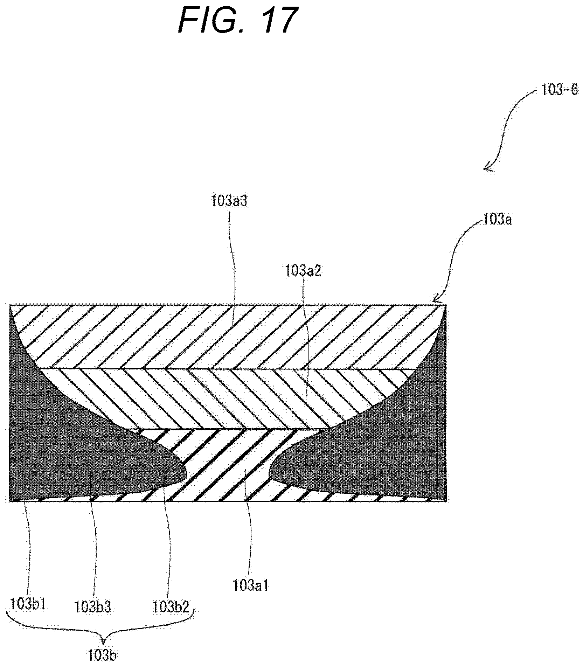

Fig. 17 is a cross-sectional view of an oxide confinement layer 103-6 of a surface-emitting element according to Modification 6 of Example 1 of the embodiment of the present technology.

The surface-emitting element according to Modification 6 has a similar configuration to that of the surface-emitting element according to Example 1 except that a non-oxidized region 103a of the oxide confinement layer 103-6 has a multilayer structure including three semiconductor layers (a semiconductor layer 103a1 and two semiconductor layers 103a2) and the oxidized region 103b does not include the middle peripheral portion MCP as illustrated in Fig. 17.

In the surface-emitting element according to Modification 6, the Al composition of the semiconductor layer 103a1 located at one end (for example, the lower end) in the stacking direction among the three semiconductor layers (the semiconductor layer 103a1 and the two semiconductor layers 103a2) constituting the multilayer structure of the non-oxidized region 103a is the highest, and the Al composition of the semiconductor layer 103a3 located at another end in the stacking direction is the lowest.

The semiconductor layer 103a1 includes, for example, AlAs. The semiconductor layer 103a2 includes, for example, $Al_\alpha GaAs$. The semiconductor layer 103a3 includes, for example, $Al_\beta GaAs$. Here, $0 < \beta < \alpha < 1$

In the oxide confinement layer 103-6, each of the first to third tapered portions 103b1, 103b2, and 103b3 is not parallel to the in-plane direction on both of one surface and another surface facing each other in the thickness direction. Here, each tapered portion of the oxidized region 103b has a vertically symmetrical shape. Note that the oxide confinement layer 103-6 in Fig. 17 may be turned upside down.

Also in the surface-emitting element according to Modification 6, it is preferable that at least one of the above Expressions (1) to (7) is satisfied. Note that Expression (8) may be satisfied instead of Expression (6), or Expression (8) may be satisfied instead of Expression (7).

With the surface-emitting element according to Modification 6, effects are obtained generally similar to those of the surface-emitting element 10 according to Example 1.

(Surface-Emitting Element According to Modification 7 of Example 1 of Embodiment of Present Technology)

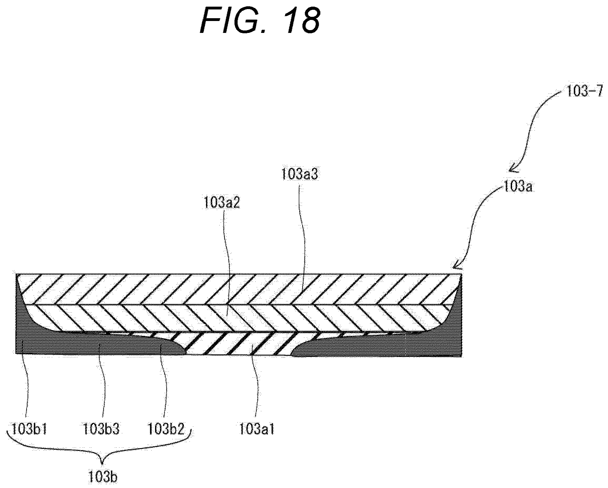

Fig. 18 is a cross-sectional view of an oxide confinement layer 103-7 of a surface-emitting element according to Modification 7 of Example 1 of the embodiment of the present technology.

The surface-emitting element according to Modification 7 has a similar configuration to that of the surface-emitting element according to Example 1 except that a non-oxidized region 103a of the oxide confinement layer 103-7 has a multilayer structure including three semiconductor layers (a semiconductor layer 103a1, a semiconductor layer 103a2, and a semiconductor layer 103a3) as illustrated in Fig. 18.

In the surface-emitting element according to Modification 7, the Al composition of the semiconductor layer 103a1 located at one end (for example, the lower end) in the stacking direction among the three semiconductor layers (the semiconductor layer 103a1, the semiconductor layer 103a2, and the semiconductor layer 103a3) constituting the multilayer structure of the non-oxidized region 103a is the highest, and the Al composition of the semiconductor layer 103a3 located at another end (for example, the upper end) in the stacking direction is the lowest.

The semiconductor layer 103a1 includes, for example, AlAs. The semiconductor layer 103a2 includes, for example, $Al_\alpha GaAs$. The semiconductor layer 103a3 includes, for example, $Al_\beta GaAs$. Here, $0 < \beta < \alpha < 1$

In the oxide confinement layer 103-7, each of the first to third tapered portions 103b1, 103b2, and 103b3 is not parallel to the in-plane direction on one (for example, the upper surface) of one surface and another surface facing each other in the thickness direction, and is parallel to the in-plane direction on the another surface (for example, the lower surface). Here, in the oxide confinement layer 103-7, each tapered portion has a vertically symmetrical shape. The oxide confinement layer 103-7 in Fig. 18 may be turned upside down.

Also in the surface-emitting element according to Modification 7, it is preferable that at least one of the above Expressions (1) to (7) is satisfied. Note that Expression (8) may be satisfied instead of Expression (6), or Expression (8) may be satisfied instead of Expression (7).

With the surface-emitting element according to Modification 7, effects are obtained generally similar to those of the surface-emitting element 10 according to Example 1.

(Surface-Emitting Element According to Modification 8 of Example 1 of Embodiment of Present Technology)

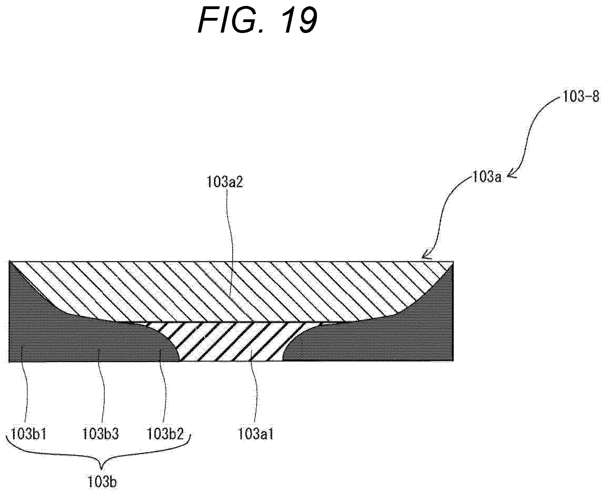

Fig. 19 is a cross-sectional view of an oxide confinement layer 103-8 of a surface-emitting element according to Modification 8 of Example 1 of the embodiment of the present technology.

The surface-emitting element according to Modification 8 has a similar configuration to that of the surface-emitting element according to Example 1 except that a non-oxidized region 103a of the oxide confinement layer 103-8 has a multilayer structure including two semiconductor layers (a semiconductor layer 103a1 and a semiconductor layer 103a2) as illustrated in Fig. 19.

In the surface-emitting element according to Modification 8, the Al composition of the semiconductor layer 103a1 located at one end (for example, the lower end) in the stacking direction among the two semiconductor layers (the semiconductor layer 103a1 and the semiconductor layer 103a2) constituting the multilayer structure of the non-oxidized region 103a is higher than that of the semiconductor layer 103a3 located at another end (for example, the upper end) in the stacking direction.

The semiconductor layer 103a1 includes, for example, AlAs. The semiconductor layer 103a2 includes, for example, $Al_\alpha GaAs$. Here, $0 < \alpha < 1$

In the oxide confinement layer 103-8, each of the first to third tapered portions 103b1, 103b2, and 103b3 is not parallel to the in-plane direction on one (for example, the upper surface) of one surface and another surface facing each other in the thickness direction, and is parallel to the in-plane direction on the another surface (for example, the lower surface). Here, in the oxide confinement layer 103-8, each tapered portion has a vertically asymmetrical shape. The oxide confinement layer 103-8 in Fig. 19 may be turned upside down.

Also in the surface-emitting element according to Modification 8, it is preferable that at least one of the above Expressions (1) to (7) is satisfied. Note that Expression (8) may be satisfied instead of Expression (6), or Expression (8) may be satisfied instead of Expression (7).

With the surface-emitting element according to Modification 8, effects are obtained generally similar to those of the surface-emitting element 10 according to Example 1.

<2. Surface-Emitting Element According to Example 2 of Embodiment of Present Technology)

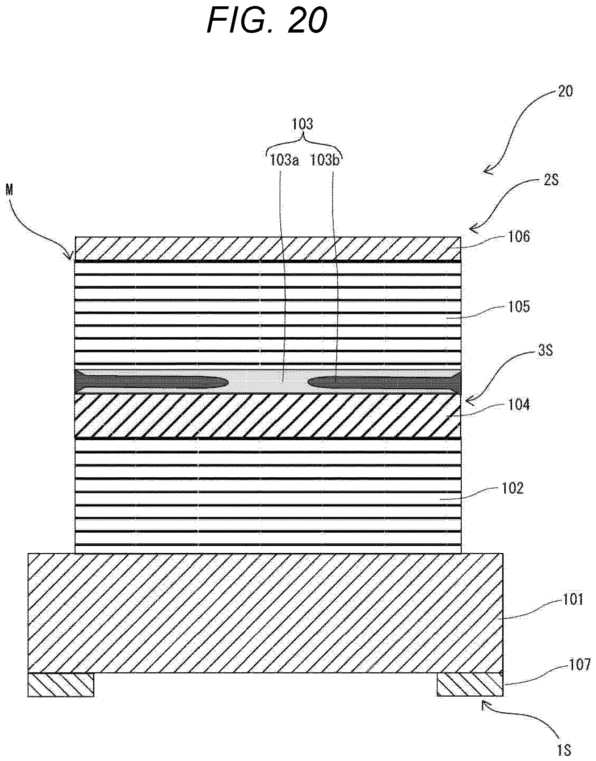

Fig. 20 is a cross-sectional view of a surface-emitting element 20 according to Example 2 of the embodiment of the present technology.

As illustrated in Fig. 20, the surface-emitting element 20 according to Example 2 has a similar configuration to that of the surface-emitting element 10 according to Example 1 except that a positional relationship between the oxide confinement layer 103 and the light-emitting layer 104 is vertically reversed.

With the surface-emitting element 20 according to Example 2, effects are obtained similar to those of the surface-emitting element 10 according to Example 1.

<3. Surface-Emitting Element According to Example 3 of Embodiment of Present Technology)

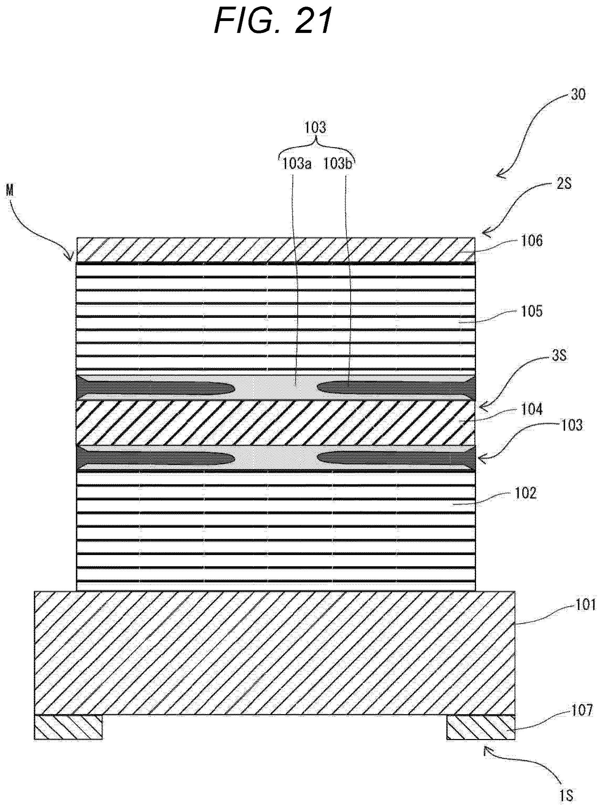

Fig. 21 is a cross-sectional view of a surface-emitting element 30 according to Example 3 of the embodiment of the present technology.

As illustrated in Fig. 21, the surface-emitting element 30 according to Example 3 has a similar configuration to that of the surface-emitting element 10 according to Example 1 except that it includes a plurality of (for example, two) stacked oxide confinement layers 103, and the light-emitting layer 104 is disposed between the two adjacent oxide confinement layers 103.

With the surface-emitting element 30 according to Example 3, a high-efficiency VCSEL that produces effects similar to those of the surface-emitting element 10 according to Example 1 can be achieved.

<4. Surface-Emitting Element According to Example 4 of Embodiment of Present Technology)

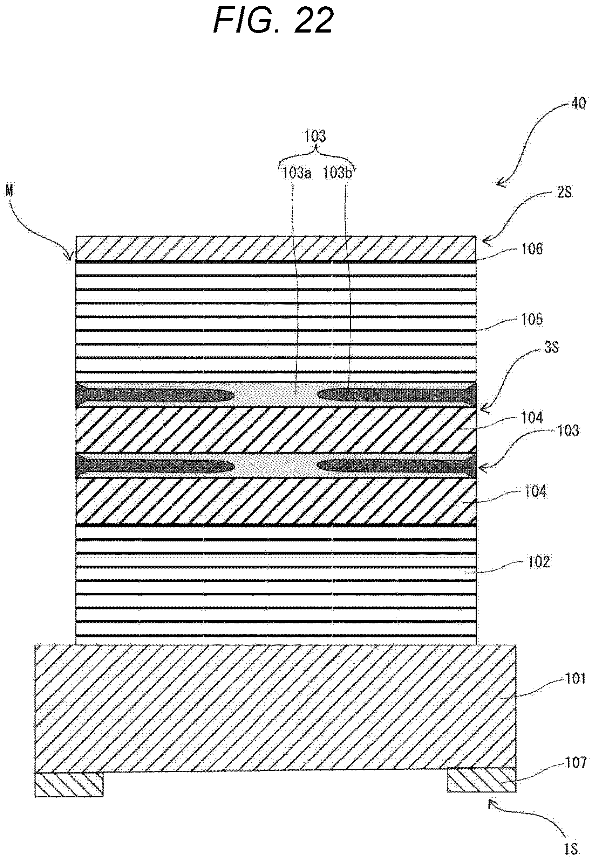

Fig. 22 is a cross-sectional view of a surface-emitting element 40 according to Example 4 of the embodiment of the present technology.
As illustrated in Fig. 22, the surface-emitting element 40 according to Example 4 has a similar configuration to that of the surface-emitting element 10 according to Example 1 except that it includes a plurality of (for example, two) stacked light-emitting layers 104 and a plurality of (for example, two) oxide confinement layers 103, and the light-emitting layers 104 and the oxide confinement layers 103 are alternately arranged.
With the surface-emitting element 40 according to Example 4, a high-efficiency and high-power VCSEL that produces effects similar to those of the surface-emitting element 10 according to Example 1 can be achieved.

<5. Surface-Emitting Element According to Example 5 of Embodiment of Present Technology)

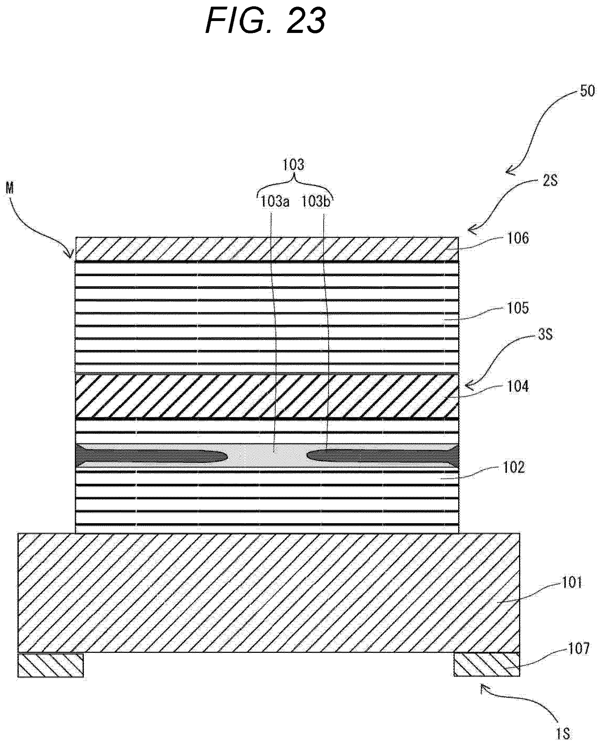

Fig. 23 is a cross-sectional view of a surface-emitting element 50 according to Example 5 of the embodiment of the present technology.
As illustrated in Fig. 23, the surface-emitting element 50 according to Example 5 has a similar configuration to that of the surface-emitting element 10 according to Example 1 except that the oxide confinement layer 103 is arranged in the first semiconductor multilayer mirror 102.
With the surface-emitting element 50 according to Example 5, effects are obtained similar to those of the surface-emitting element 10 according to Example 1.

<6. Surface-Emitting Element According to Example 6 of Embodiment of Present Technology)

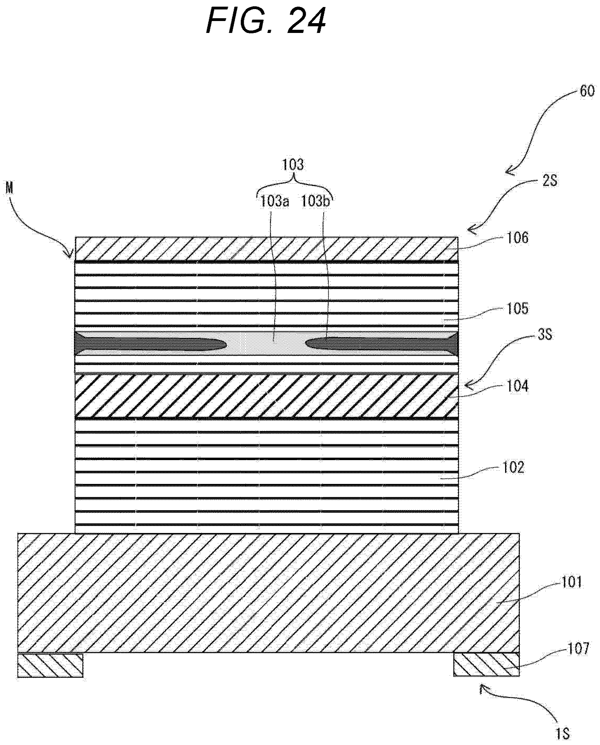

Fig. 24 is a cross-sectional view of a surface-emitting element 60 according to Example 6 of the embodiment of the present technology.
As illustrated in Fig. 24, the surface-emitting element 60 according to Example 6 has a similar configuration to that of the surface-emitting element 10 according to Example 1 except that the oxide confinement layer 103 is arranged in the second semiconductor multilayer mirror 105.
With the surface-emitting element 60 according to Example 6, effects are obtained similar to those of the surface-emitting element 10 according to Example 1.

<7. Surface-Emitting Element According to Example 7 of Embodiment of Present Technology)

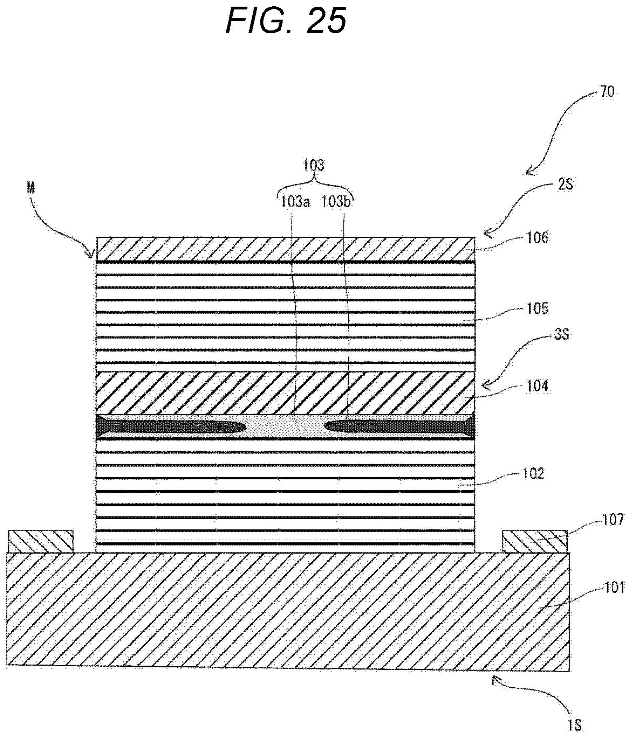

Fig. 25 is a cross-sectional view of a surface-emitting element 70 according to Example 7 of the embodiment of the present technology.
As illustrated in Fig. 25, the surface-emitting element 70 according to Example 7 has a similar configuration to that of the surface-emitting element 10 according to Example 1 except that the anode electrode 107 is provided on the front surface (upper surface) of the substrate 101 in such a way as to surround the mesa M.
With the surface-emitting element 70 according to Example 7, it is possible to provide a VCSEL exhibiting similar effects to those of the surface-emitting element 10 according to Example 1, in which the anode electrode 107 can also be bonded to another substrate 200 via bumps.

<8. Surface-Emitting Element According to Example 8 of Embodiment of Present Technology)

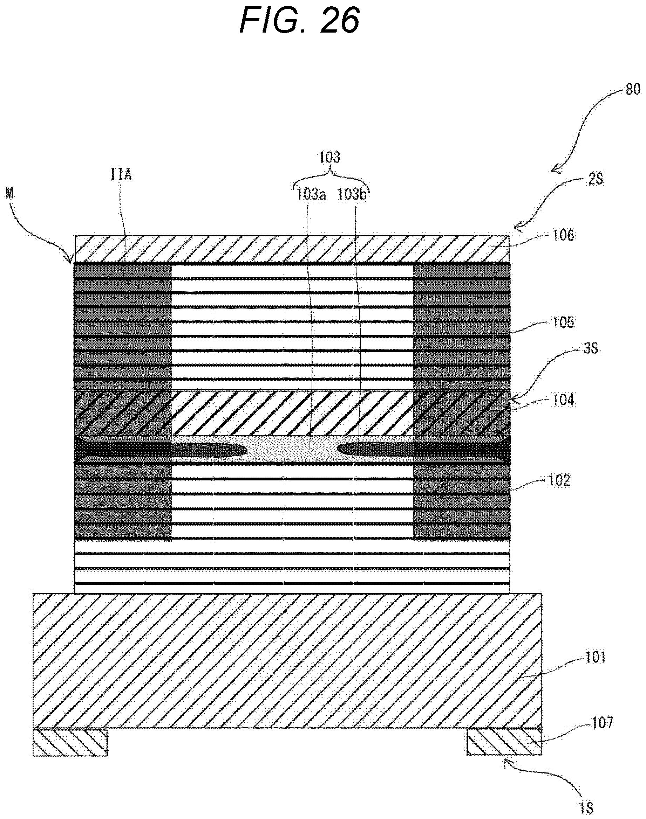

Fig. 26 is a cross-sectional view of a surface-emitting element 80 according to Example 8 of the embodiment of the present technology.
As illustrated in Fig. 26, the surface-emitting element 80 according to Example 8 has a similar configuration to that of the surface-emitting element 10 according to Example 1 except that an ion implantation region IIA is provided for the mesa M in addition to the oxide confinement layer 103. The ion implantation region IIA has a circumferential shape surrounding the light-emitting region of the light-emitting layer 104 in plan view.
With the surface-emitting element 80 according to Example 8, a high-efficiency VCSEL that produces effects similar to those of the surface-emitting element 10 according to Example 1 can be provided.

<9. Surface-Emitting Element According to Example 9 of Embodiment of Present Technology)

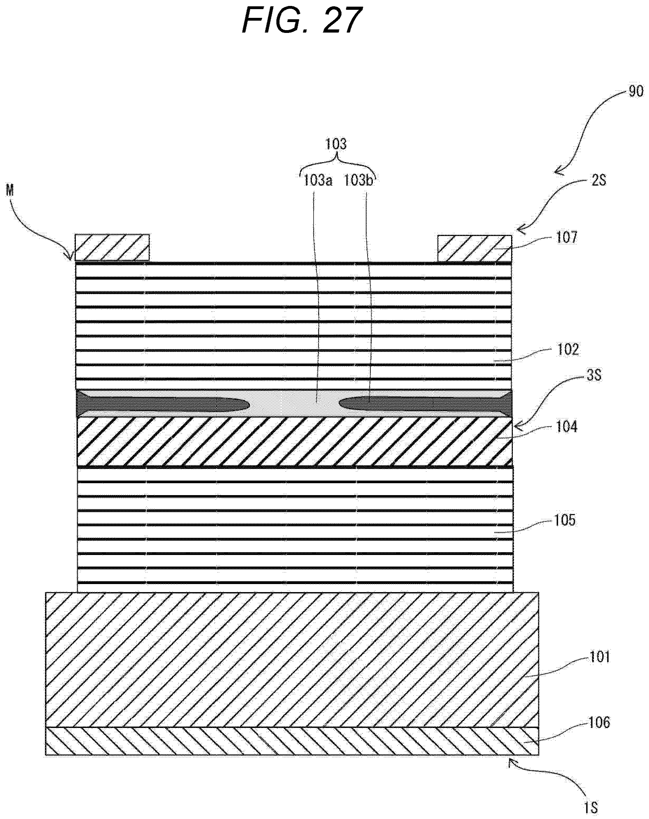

Fig. 27 is a cross-sectional view of a surface-emitting element 90 according to Example 9 of the embodiment of the present technology.

As illustrated in Fig. 27, the surface-emitting element 90 according to Example 9 has a similar configuration to that of the surface-emitting element 10 according to Example 1 except that it is of the front surface emission type.

In the surface-emitting element 90, the anode electrode 107 is provided in a circumferential shape (for example, a ring shape) at the top of the mesa M in such a way as to surround the light-emitting region in plan view, and the cathode electrode 106 is provided as a blanket layer on the back surface (lower surface) of the substrate 101. The second semiconductor multilayer mirror 105, the light-emitting layer 104, the oxide confinement layer 103, and the first semiconductor multilayer mirror 102 are stacked on the substrate 101 in this order.

With the surface-emitting element 90 according to Example 8, a high-efficiency VCSEL of the front surface emission type that produces effects similar to those of the surface-emitting element 10 according to Example 1 can be provided.

<10. Surface-Emitting Element According to Example 10 of Embodiment of Present Technology)

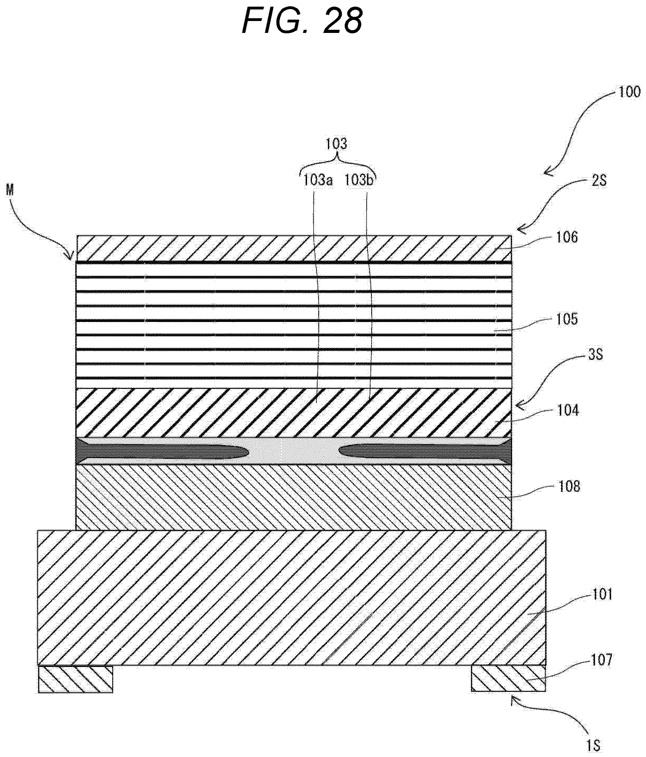

Fig. 28 is a cross-sectional view of a surface-emitting element 100 according to Example 10 of the embodiment of the present technology.

As illustrated in Fig. 28, the surface-emitting element 100 according to Example 10 has a generally similar configuration to that of the surface-emitting element 10 according to Example 1 except that it is a light-emitting diode (LED) of the back surface emission type.

The surface-emitting element 100 has a similar configuration to that of the surface-emitting element 10 according to Example 1 except that a cladding layer 108 (for example, a p-AlGaAs layer) is provided instead of the first semiconductor multilayer mirror 102.

In the surface-emitting element 100, combined light of light emitted downward from the light-emitting layer 104 and light emitted upward from the light-emitting layer 104 and reflected from the second semiconductor multilayer mirror 105 and the cathode electrode 106 is emitted to the back surface side of the substrate 101.

With the surface-emitting element 100 according to Example 10, a high-power LED of the back surface emission type that produces effects similar to those of the surface-emitting element 10 according to Example 1 can be provided.

<11. Surface-Emitting Element According to Example 11 of Embodiment of Present Technology)

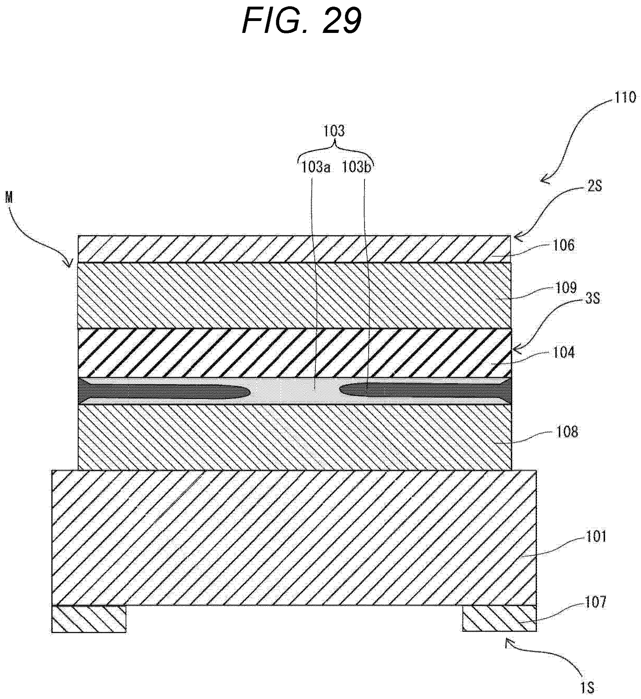

Fig. 29 is a cross-sectional view of a surface-emitting element 110 according to Example 11 of the embodiment of the present technology.

As illustrated in Fig. 29, the surface-emitting element 110 according to Example 11 has a generally similar configuration to that of the surface-emitting element 10 according to Example 1 except that it is a light-emitting diode (LED) of the back surface emission type.

The surface-emitting element 110 has a similar configuration to that of the surface-emitting element 10 according to Example 1 except that a cladding layer 108 (for example, a p-AlGaAs layer) is provided instead of the first semiconductor multilayer mirror 102, and a cladding layer 109 (for example, an n-AlGaAs layer) is provided instead of the second semiconductor multilayer mirror 105.

In the surface-emitting element 110, combined light of light emitted downward from the light-emitting layer 104 and light emitted upward from the light-emitting layer 104 and reflected from the cathode electrode 106 is emitted to the back surface side of the substrate 101.

With the surface-emitting element 100 according to Example 10, an LED of the back surface emission type that produces effects similar to those of the surface-emitting element according to Example 1 can be provided.

<12. Surface-Emitting Element According to Example 12 of Embodiment of Present Technology)

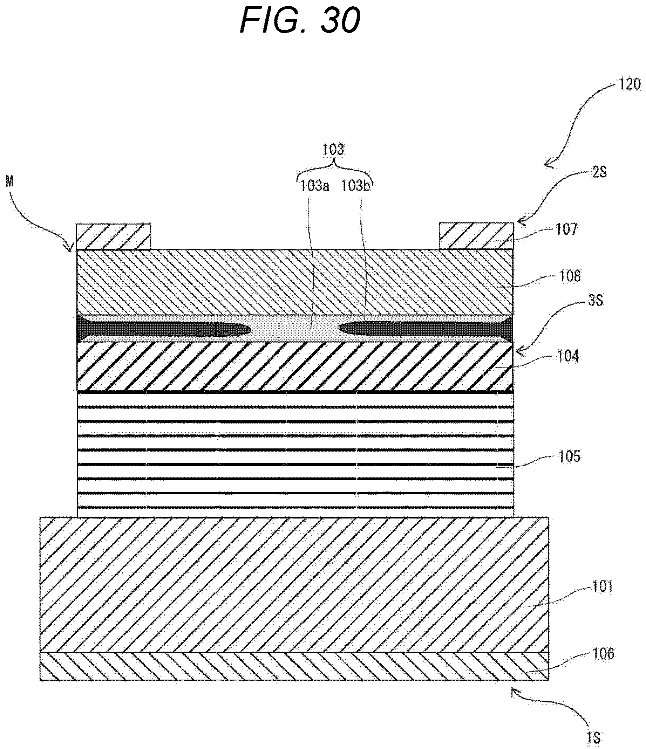

Fig. 30 is a cross-sectional view of a surface-emitting element 120 according to Example 12 of the embodiment of the present technology.

As illustrated in Fig. 30, the surface-emitting element 120 according to Example 12 has a generally similar configuration to that of the surface-emitting element 90 according to Example 9 except that it is a light-emitting diode (LED) of the front surface emission type.

The surface-emitting element 120 has a similar configuration to that of the surface-emitting element 90 according to Example 9 except that a cladding layer 108 (for example, a p-AlGaAs layer) is provided instead of the first semiconductor multilayer mirror 102.

In the surface-emitting element 120, combined light of light emitted upward from the light-emitting layer 104 and light emitted downward from the light-emitting layer 104 and reflected from the second semiconductor multilayer mirror 105 is emitted to the back surface side of the cladding layer 108.

With the surface-emitting element 120 according to Example 12, a high-power LED of the front surface emission type that produces effects similar to those of the surface-emitting element according to Example 1 can be provided. Note that, in the surface-emitting element 120, the second semiconductor multilayer mirror 105 may be replaced with a cladding layer 109 (for example, an n-AlGaAs layer) to constitute an LED of the front surface emission type.

<13. Surface-Emitting Element According to Example 13 of Embodiment of Present Technology)

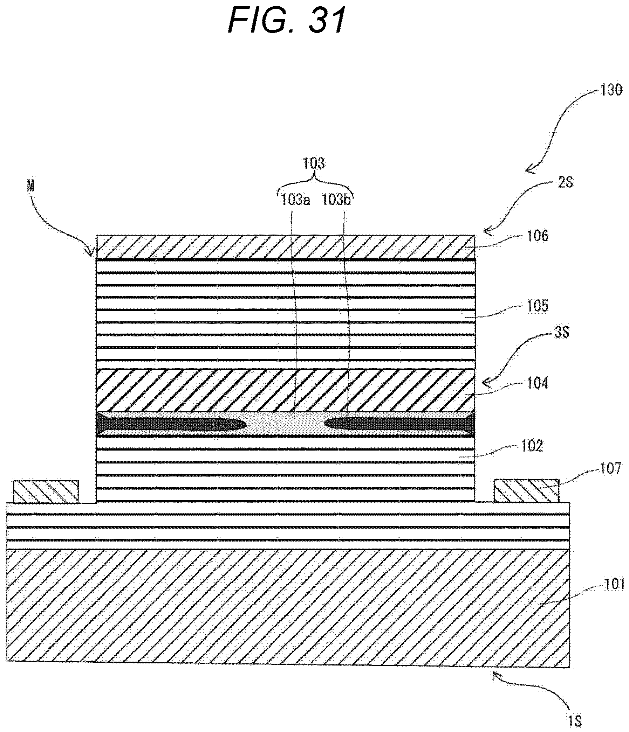

Fig. 31 is a cross-sectional view of a surface-emitting element 130 according to Example 13 of the embodiment of the present technology.

As illustrated in Fig. 31, the surface-emitting element 130 according to Example 13 has a generally similar configuration to that of the surface-emitting element 10 according to Example 1 except that it is an intra-cavity VCSEL.

In the surface-emitting element 130, a bottom surface of the mesa M is located in the first semiconductor multilayer mirror 102, and the anode electrode 107 is provided in a region around the mesa M of the first semiconductor multilayer mirror 102 in such a way as to surround the mesa M. In this case, a semiinsulating substrate (for example, i-GaAs) may also be used as the substrate 101.

With the surface-emitting element 130 according to Example 13, a high-efficiency VCSEL of the back surface emission type that produces effects similar to those of the surface-emitting element 10 according to Example 1 can be provided.

<14. Light Source Apparatus Including Surface-Emitting Element According to Example 1 of Embodiment of Present Technology)

Fig. 32 is a cross-sectional view of a light source apparatus 1 including the surface-emitting element 10 according to Example 1 of the embodiment of the present technology.

As illustrated in Fig. 32, the light source apparatus 1 includes, as an example, a plurality of surface-emitting elements 10 and another substrate 200 (for example, a driver, a wiring board, or the like).

The cathode electrode 106 provided at the top of each of mesas M of the plurality of surface-emitting elements 10 are bonded to the another substrate 200 via bumps BP. That is, each of the surface-emitting elements 10 is flip-chip mounted (junction-down mounted) on the another substrate 200.

The plurality of surface-emitting elements 10 shares the substrate 101, and further shares the anode electrode 107 provided on the back surface (lower surface) of the substrate 101 in such a way as to surround the light-emitting region of each surface-emitting element 10 in plan view. That is, the plurality of surface-emitting elements 10 has an electrode configuration in which the cathode is independent and the anode is common, and each surface-emitting element 10 can be independently driven.

With the light source apparatus 1, since the plurality of surface-emitting elements 10 is provided, occurrence of cracks is effectively suppressed even during junction-down mounting in which a large stress can be generated in the mesa M of each surface-emitting element 10, and a light source apparatus having high electro-optical characteristics and reliability can be achieved. Note that the light source apparatus 1 may include a single surface-emitting element 10, instead.

<15. Other Modifications of Present Technology>

The present technology is not limited to the above-described examples and modifications of the embodiment, and can be appropriately modified.

For example, in the surface-emitting element, the outer peripheral portion OCP and/or the inner peripheral portion ICP of the oxidized region 103b of the oxide confinement layer 103 may be a non-tapered portion having a constant thickness. In a case where both the outer peripheral portion OCP and the inner peripheral portion ICP are non-tapered portions, the middle peripheral portion MCP may have a plurality of tapered portions at different positions in the radial direction. In a case where one of the outer peripheral portion OCP and the inner peripheral portion ICP is a non-tapered portion, the middle peripheral portion MCP may have a tapered portion.

For example, in the surface-emitting element, the outer peripheral portion OCP, the inner peripheral portion ICP, and/or the middle peripheral portion MCP of the oxidized region 103b of the oxide confinement layer 103 may have a non-tapered portion having a constant thickness in addition to the tapered portion.

For example, the surface-emitting element may include a contact layer at the top of the mesa M and/or between the substrate 101 and the semiconductor multilayer mirror.

In the surface-emitting element, a cladding layer (spacer layer) may be provided between the light-emitting layer 104 and the first semiconductor multilayer mirror 102 and between the light-emitting layer 104 and the second semiconductor multilayer mirror 105.

A plurality of surface-emitting elements may be arranged one-dimensionally or two-dimensionally to form a surface-emitting element array.

For example, the substrate 101 may be a Ge substrate, a Si substrate, a GaN substrate, an InP substrate, or the like. In any case, the semiconductor layer stacked on the substrate 101 is preferably appropriately selected in such a way as to be lattice-matched with the material of the substrate 101. For the surface-emitting element, a material having any light-emission wavelength included in a wavelength band of 200 to 2000 nm can be used.

At least one of the first and second structures 1S and 2S is not limited to the semiconductor multilayer mirror, but may include a mirror including one or a combination of two or more selected from a semiconductor, a dielectric, and a metal.

In the surface-emitting element according to each of the above examples and modifications, the conductivity types (p-type and n-type) of the first and second semiconductor structures may be reversed. In this case, a positional relationship between the anode electrode and the cathode electrode needs to be reversed.

A part of the configuration of the surface-emitting element according to each of the above embodiments and modifications may be combined within a range not contradictory to each other.

In each of the above embodiments and modifications, the material, conductivity type, thickness, width, numerical value, shape, size, and the like of each layer constituting the surface-emitting element can be appropriately changed within a range functioning as the surface-emitting element.

<16. Application Examples for Electronic Devices>

The technology (present technology) according to the present disclosure can be applied to various products (electronic devices). For example, the technology according to the present disclosure may be implemented as an apparatus mounted on any type of mobile body such as an automobile, an electric vehicle, a hybrid electric vehicle, a motorcycle, a bicycle, a personal mobility, an airplane, a drone, a ship, or a robot, or a low power consumption device (for example, a smartphone, a smartwatch, a tablet, a mouse, or the like).

The surface-emitting element according to the present technology can also be employed as, for example, a light source of a device (for example, a printer, a copier, a projector, a head-mounted display, a head-up display, or the like) that forms or displays an image by light.

<17. Example in Which Surface-Emitting Element Is Employed in Distance Measuring Apparatus>

An application example of the surface-emitting element 10 according to the first embodiment will be described hereinafter.

Fig. 33 illustrates an example of a schematic configuration of a distance measuring apparatus 1000 (ranging apparatus) including the surface-emitting element 10 as an example of an electronic device according to the present technology. The distance measuring apparatus 1000 measures a distance to a subject S by a time of flight (TOF) method. The distance measuring apparatus 1000 includes the surface-emitting element 10. The distance measuring apparatus 1000 includes, for example, the surface-emitting element 10, a light receiving device 125, lenses 128 and 138, a signal processing section 145, a control section 155, a display section 165, and a storage section 175.

The light receiving device 125 receives the light emitted from the surface-emitting element 10 and reflected by the subject S (object). That is, the light receiving device 125 detects the light reflected by the subject S. The lens 128 is a lens for collimating the light emitted from the surface-emitting element 10, and is, for example, a collimating lens. The lens 138 is a lens for collecting light reflected by the subject S and guiding the light to the light receiving device 125, and is, for example, a condenser lens.

The signal processing section 145 is a circuit for generating a signal corresponding to a difference between a signal input from the light receiving device 125 and a reference signal input from the control section 155. The control section 155 includes, for example, a time to digital converter (TDC). The reference signal may be a signal input from the control section 155, or may be an output signal of a detection section that directly detects the output of the surface-emitting element 10. The control section 155 is, for example, a processor that controls the surface-emitting element 10, the light receiving device 125, the signal processing section 145, the display section 165, and the storage section 175. The control section 155 is a circuit that measures the distance to the subject S on the basis of the signal generated by the signal processing section 145. The control section 155 generates a video signal for displaying information on the distance to the subject S, and outputs the video signal to the display section 165. The display section 165 displays information on the distance to the subject S on the basis of the video signal input from the control section 155. The control section 155 stores information on the distance to the subject S in the storage section 175.

In the present application example, instead of the surface-emitting element 10, any one of the surface-emitting elements according to Modifications 1 to 8, the surface-emitting elements 20, 30, 40, 50, 60, 70, 80, 90, 100, 110, 120, and 130, and the light source apparatus 1 may be employed for the distance measuring apparatus 1000.

<18. Example in Which Distance Measuring Apparatus Is Mounted on Mobile Body>

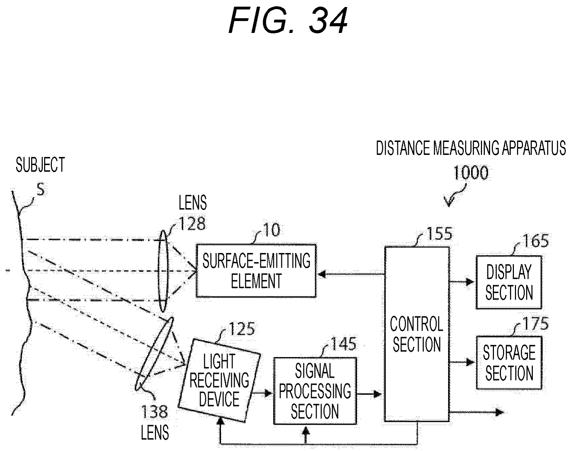

Fig. 34 is a block diagram illustrating a schematic configuration example of a vehicle control system, which is an example of a mobile body control system to which the technology of the present disclosure can be applied.

A vehicle control system 12000 includes a plurality of electronic control units connected to each other via a communication network 12001. In the example depicted in Fig. 34, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls operation of devices related to a driving system of a vehicle in accordance with various programs. For example, the driving system control unit 12010 functions as a control device for a driving force generating device for generating driving force of the vehicle, such as an internal combustion engine or a driving motor, a driving force transmitting mechanism for transmitting the driving force to wheels, a steering mechanism for adjusting a steering angle of the vehicle, a braking device for generating braking force of the vehicle, and the like.

The body system control unit 12020 controls operation of various devices provided to a vehicle body in accordance with various programs. For example, the body system control unit 12020 functions as a control device for a keyless entry system, a smart key system, a power window device, or various lamps such as a headlamp, a back-up lamp, a brake lamp, a turn indicator, or a fog lamp. In this case, a radio wave transmitted from a mobile device that substitutes for a key or signals of various switches may be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, a distance measuring apparatus 12031 is connected to the outside-vehicle information detecting unit 12030. The distance measuring apparatus 12031 includes the distance measuring apparatus 1000 described above. The outside-vehicle information detecting unit 12030 causes the distance measuring apparatus 12031 to measure a distance to an object (subject S) outside the vehicle, and acquires distance data acquired by the measurement. The outside-vehicle information detecting unit 12030 may perform object detection processing of detecting a person, a vehicle, an obstacle, a sign, or the like on the basis of the acquired distance data.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle, the information being acquired by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS), the functions including vehicle collision avoidance or shock mitigation, following driving based on a following distance, vehicle speed maintaining driving, vehicle collision warning, vehicle lane departure warning, and the like.

Furthermore, the microcomputer 12051 can perform cooperative control intended for automated driving in which the vehicle travels autonomously without depending on the driver's operation, or the like, by controlling the driving force generating device, the steering mechanism, the braking device, or the like on the basis of the information about surroundings of the vehicle, the information being acquired by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent glare such as switching from high beam to low beam, by controlling the headlamp in accordance with a position of a preceding vehicle or an oncoming vehicle detected by the outside-vehicle information detecting unit 12030.

The sound/image output section 12052 transmits an output signal of at least one of a sound or an image to an output device capable of visually or auditorily notifying an occupant of the vehicle or the outside of the vehicle of information. In the example in Fig. 34, an audio speaker 12061, a display section 12062, and an instrument panel 12063 are illustrated as examples of the output device. The display section 12062 may, for example, include at least one of an on-board display or a head-up display.

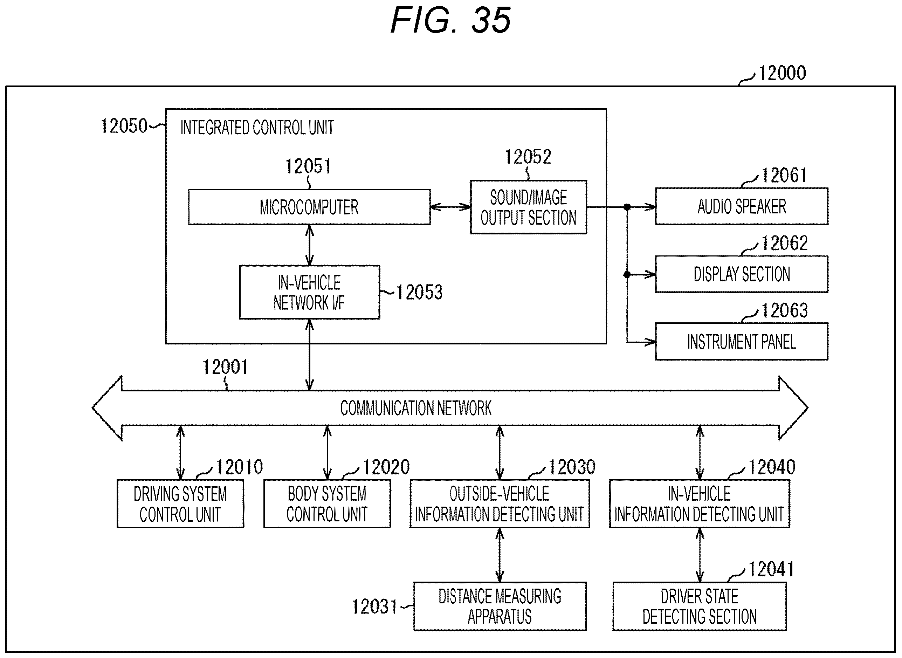

Fig. 35 is a view illustrating an example of an installation position of the distance measuring apparatus 12031.

In Fig. 35, a vehicle 12100 includes distance measuring apparatuses 12101, 12102, 12103, 12104, and 12105 as the distance measuring apparatus 12031.

For example, the distance measuring apparatuses 12101, 12102, 12103, 12104, and 12105 are provided at positions such as a front nose, sideview mirrors, a rear bumper, a back door, an upper portion of a windshield in a vehicle interior, and the like, of the vehicle 12100. The distance measuring apparatus 12101 provided at the front nose and the distance measuring apparatus 12105 provided at the upper portion of the windshield in the vehicle interior mainly acquire data of the front side of the vehicle 12100. The distance measuring apparatuses 12102 and 12103 provided at the sideview mirrors mainly acquire data of the sides of the vehicle 12100. The distance measuring apparatus 12104 provided at the rear bumper or the back door mainly acquires data of the rear side of the vehicle 12100. The data of the front side acquired by the distance measuring apparatuses 12101 and 12105 is mainly used to detect a preceding vehicle, a pedestrian, an obstacle, a traffic light, a traffic sign, or the like.

Note that Fig. 35 illustrates an example of detection ranges of the distance measuring apparatuses 12101 to 12104. A detection range 12111 indicates a detection range of the distance measuring apparatus 12101 provided at the front nose, detection ranges 12112 and 12113 indicate detection ranges of the distance measuring apparatuses 12102 and 12103 provided at the sideview mirrors, respectively, and a detection range 12114 indicates a detection range of the distance measuring apparatus 12104 provided at the rear bumper or the back door.

For example, the microcomputer 12051 may obtain a distance to each three-dimensional object within the detection ranges 12111 to 12114 and a temporal change in the distance (relative speed with respect to the vehicle 12100) on the basis of the distance data obtained from the distance measuring apparatuses 12101 to 12104, whereby particularly the nearest three-dimensional object present on a traveling path of the vehicle 12100, which travels in substantially the same direction as the vehicle 12100 at a predetermined speed (for example, equal to or more than 0 km/h), may be extracted as a preceding vehicle. Moreover, the microcomputer 12051 can set a following distance to be maintained relative to a preceding vehicle in advance, and perform automatic brake control (including following stop control), automatic acceleration control (including following start control), or the like. It is thus possible to perform cooperative control intended for automated driving in which the vehicle travels autonomously without depending on the driver's operation, or the like.

For example, on the basis of the distance data obtained from the distance measuring apparatuses 12101 to 12104, the microcomputer 12051 can extract three-dimensional object data regarding three-dimensional objects while classifying into two-wheeled vehicles, standard-sized vehicles, large-sized vehicles, pedestrians, and other three-dimensional objects such as utility poles, and use the three-dimensional object data for automatic avoidance of obstacles. For example, the microcomputer 12051 identifies obstacles around the vehicle 12100 as obstacles that the driver of the vehicle 12100 can recognize visually and obstacles that are difficult for the driver of the vehicle to recognize visually. Then, the microcomputer 12051 determines a collision risk indicating a risk of collision with each obstacle, and in a situation in which the collision risk is greater than or equal to a set value and there is a possibility of collision, can perform driving assistance to avoid collision by outputting a warning to the driver via the audio speaker 12061 or the display section 12062, and performing forced deceleration or avoidance steering via the driving system control unit 12010.

An example of the mobile body control system to which the technology according to the present disclosure can be applied has been described above. The technology according to the present disclosure may be applied to the distance measuring apparatus 12031 in the configuration described above.

Furthermore, the present technology may also adopt the following configurations.

(1) A surface-emitting element including:

a first structure including a first semiconductor structure;
a second structure stacked with the first structure and including a second semiconductor structure; and
a third structure arranged between the first and second structures and including a light-emitting layer, in which an oxide confinement layer is provided between a surface of the first structure on a side opposite a light-emitting layer side and the light-emitting layer and/or between a surface of the second structure on a side opposite the light-emitting layer side and the light-emitting layer,
the oxide confinement layer including:

a non-oxidized region; and
an oxidized region surrounding at least a part of the non-oxidized region, and
the oxidized region has a plurality of tapered portions whose thickness decreases toward inner peripheral ends.

(2) The surface-emitting element according to (1), in which the plurality of tapered portions is located at different positions in a radial direction of the oxidized region.

(3) The surface-emitting element according to (1) or (2), in which the oxidized region has a first tapered portion as the tapered portion in an outer peripheral portion.

(4) The surface-emitting element according to any one of (1) to (3), in which the oxidized region has a second tapered portion as the tapered portion in an inner peripheral portion.

(5) The surface-emitting element according to (4), in which a taper angle of the first tapered portion is larger than a taper angle of the second tapered portion.

(6) The surface-emitting element according to any one of (3) to (5), in which

$$d1(x_{11}) > d1(x_{12}) > \cdots > d1(x_{1n})$$

and/or

$$d2(x_{11}) > d2(x_{12}) > \cdots > d2(x_{1n})$$

are satisfied, where a thickness of a first portion for each x-coordinate and a thickness of a second portion for each x-coordinate in a case where a plane located at an arbitrary position of the oxide confinement layer in a thickness direction and parallel to an in-plane direction is defined as a reference plane, a portion of the first tapered portion on one side of the reference plane is defined as the first portion, a portion on another side is defined as the second portion, and an x-axis is set in a direction from an outer peripheral end to an inner peripheral end of the oxidized region along the reference plane are denoted by $d1(x)$ and $d2(x)$, respectively, and $x_{11} < X12 < \cdots < x_{1n}$.

(7) The surface-emitting element according to any one of (3) to (6), in which

$$[\{d1(0) + d2(0)\} - \{d1(x_{1max}) + d2(x_{1max})\}]/x_{1max} \geq 0.05$$

is satisfied, where a thickness of the first portion for each x-coordinate and a thickness of the second portion for each x-coordinate in a case where a plane located at an arbitrary position of the oxide confinement layer in a thickness direction and parallel to an in-plane direction is defined as a reference plane, an x-axis is set in a direction from an outer peripheral end to an inner peripheral end of the oxidized region along the reference plane, an x-coordinate of an outer peripheral end of the first tapered portion is 0, and an x-coordinate of an inner peripheral end of the first tapered portion is $x_{1max}$ are denoted by $d1(x)$ and $d2(x)$, respectively.

(8) The surface-emitting element according to any one of (4) to (7), in which

$$[d1(x_{21}) + d2(x_{21})] > [d1(x_{22}) + d2(x_{22})] > \cdots > [d1(x_{2n}) + d2(x_{2n})]$$

are satisfied, where a thickness of a first portion for each x-coordinate and a thickness of a second portion for each x-coordinate in a case where a plane located at an arbitrary position of the oxide confinement layer in a thickness direction and parallel to an in-plane direction is defined as a reference plane, a portion of the second tapered portion on one side of the reference plane is defined as the first portion, a portion on another side is defined as the second portion, and an x-axis is set in a direction from an outer peripheral end to an inner peripheral end of the oxidized region along the reference plane are denoted by $d1(x)$ and $d2(x)$, respectively, and $X21 < X22 < \cdots < x_{2n}$.

(9) The surface-emitting element according to any one of (4) to (8), in which the oxidized region has a middle peripheral portion between the outer peripheral portion and the inner peripheral portion.

(10) The surface-emitting element according to (9), in which

$$x_{2max} - x_{3max} = 1 \ \mu m \ and/or \ x_{1max} = 1 \ \mu m$$

are satisfied, where a plane located at an arbitrary position of the oxide confinement layer in a thickness direction and parallel to the in-plane direction is defined as a reference plane, an x-axis is set in a direction from an outer peripheral end toward an inner peripheral end of the oxidized region along the reference plane, a range occupied by the outer peripheral portion in an x-axis direction is set as $0 \leq x \leq x_{1max}$, a range occupied by the middle peripheral portion in the x-axis direction is set as $x_{3min} \leq x \leq x_{3max}$, and a range occupied by the inner peripheral portion in the x-axis direction is set as $x_{2min} \leq x \leq x_{2max}$.

(11) The surface-emitting element according to (9) or (10), in which the middle peripheral portion has a constant thickness.

(12) The surface-emitting element according to (9) or (10), in which the middle peripheral portion has a third tapered portion as the tapered portion.

(13) The surface-emitting element according to (12), in which a taper angle of the third tapered portion is smaller than a taper angle of the second tapered portion.
(14) The surface-emitting element according to any one of (9) to (13), in which

$[d1(x_{31}) + d2(x_{31})] \geq [d1(x_{32}) + d2(x_{32})] \geq \cdots \geq [d1(x_{3n}) + d2(x_{3n})]$

is satisfied, where a thickness of a first portion for each x-coordinate and a thickness of a second portion for each x-coordinate in a case where a plane located at an arbitrary position of the oxide confinement layer in a thickness direction and parallel to an in-plane direction is defined as a reference plane, a portion of the middle peripheral portion on one side of the reference plane is defined as the first portion, a portion on another side is defined as the second portion, and an x-axis is set in a direction from an outer peripheral end to an inner peripheral end of the oxidized region along the reference plane are denoted by d1(x) and d2(x), respectively, and $X31 < X32 < \cdots < x_{3n}$.
(15) The surface-emitting element according to any one of (12) to (14), in which

$$[\{d1(x_{3min}) + d2(x_{3min})\} - \{d1(x_{3max}) + d2(x_{3max})\}]/(x_{3max} - x_{3min}) \leq 0.01$$

is satisfied, where a thickness of a first portion for each x-coordinate and a thickness of a second portion for each x-coordinate in a case where a plane located at an arbitrary position of the oxide confinement layer in a thickness direction and parallel to an in-plane direction is defined as a reference plane, a portion of the third tapered portion on one side of the reference plane is defined as the first portion, a portion on another side is defined as the second portion, an x-axis is set in a direction from an outer peripheral end to an inner peripheral end of the oxidized region along the reference plane, and an x-coordinate of an outer peripheral end of the third tapered portion is $x_{3min}$, and an x-coordinate of an inner peripheral end of the third tapered portion is $x_{3max}$ are denoted by d1(x) and d2(x), respectively.
(16) The surface-emitting element according to any one of (1) to (15), in which at least one of the plurality of tapered portions is not parallel to an in-plane direction on both of one surface and another surface facing each other in a thickness direction.
(17) The surface-emitting element according to (16), in which inclination angles of the one surface and the another surface with respect to the in-plane direction are the same.
(18) The surface-emitting element according to any one of (1) to (15), in which at least one of the plurality of tapered portions is not parallel to an in-plane direction on one of one surface and another surface facing each other in a thickness direction and is parallel to the in-plane direction on another of the one surface and the another surface.
(19) The surface-emitting element according to any one of (1) to (18), in which the non-oxidized region has a multilayer structure in which a plurality of semiconductor layers having different Al compositions is stacked.
(20) The surface-emitting element according to (19), in which, in the multilayer structure, the Al composition of the semiconductor layer at a predetermined position in a stacking direction of the first and second structures is the highest, and the Al composition of the semiconductor layer closer to the semiconductor layer at the predetermined position is higher.
(21) The surface-emitting element according to (20), in which

the plurality of semiconductor layers is an odd number of semiconductor layers, and
the predetermined position is a central position in the stacking direction.

(22) The surface-emitting element according to (21), in which

the plurality of semiconductor layers is at least three semiconductor layers, and
the predetermined position is a position of one end or another end in the stacking direction.

(23) The surface-emitting element according to (21), in which

the plurality of semiconductor layers is at least three semiconductor layers, and
the predetermined position is a position other than one end or another end in the stacking direction.

(24) The surface-emitting element according to any one of (1) to (23), in which the first structure includes a substrate on a side of the first semiconductor structure opposite the light-emitting layer side, and emits light to a side of the substrate opposite the light-emitting layer side.
(25) The surface-emitting element according to any one of (1) to (24), in which the third structure includes a plurality of the light-emitting layers stacked on each other, and

the oxide confinement layer is disposed between two adjacent light-emitting layers among the plurality of light-emitting layers.

(26) The surface-emitting element according to any one of (1) to (25), in which the oxide confinement layer is adjacent to the light-emitting layer.

(27) The surface-emitting element according to any one of (1) to (26), in which the third structure includes a plurality of the light-emitting layers stacked on each other.

(28) The surface-emitting element according to (27), in which the oxide confinement layer is disposed between two adjacent light-emitting layers among the plurality of light-emitting layers.

(29) The surface-emitting element according to any one of (1) to (28), in which a mesa is constituted by at least a part of the first semiconductor structure, the light-emitting layer, and the second semiconductor structure.

(30) The surface-emitting element according to any one of (1) to (29), in which each of the first and second structures includes a mirror.

(31) The surface-emitting element according to any one of (1) to (30), in which the oxidized region surrounds an axis passing through the center of the non-oxidized region and extending in a stacking direction of the first and second structures, and

the tapered portion becomes thinner toward the axis.

(32) A surface-emitting element array including a plurality of the surface-emitting elements according to any one of (1) to (31).

(33) A light source apparatus including

the surface-emitting element according to any one of (1) to (31); and
another substrate bonded to the surface-emitting element via a bump.

(34) An electronic device including the surface-emitting element according to any one of (1) to (31).

(35) An electronic device including the surface-emitting element array according to (32).

REFERENCE SIGNS LIST

10, 20, 30, 40, 50, 60, 70, 80, 90, 100, 110, 120, 130 Surface-emitting element
101 Substrate
102 First semiconductor multilayer mirror (first semiconductor structure)
103, 103-1, 103-2, 103-3, 103-4, 103-5, 103-6, 103-7, 103-8 Oxide confinement layer
103a Non-oxidized region
103a1, 103a2, 103a3, 103a4, 103a5 Semiconductor layer
103b Oxidized region
103b1 First tapered portion
103b2 Second tapered portion
103b3 Third tapered portion
104 Light-emitting layer
105 Second semiconductor multilayer mirror (second semiconductor structure)
1S First structure
2S Second structure
3S Third structure
SS1 First semiconductor structure
SS2 Second semiconductor structure
M Mesa
OCP Outer peripheral portion
ICP Inner peripheral portion
MCP Middle peripheral portion
BS Reference plane
81 Taper angle of first tapered portion
82 Taper angle of second tapered portion

**Claims**

1. A surface-emitting element comprising:

  a first structure including a first semiconductor structure;
  a second structure stacked with the first structure and including a second semiconductor structure; and
  a third structure arranged between the first and second structures and including a light-emitting layer, wherein

   an oxide confinement layer is provided between a surface of the first structure on a side opposite a light-emitting layer side and the light-emitting layer and/or between a surface of the second structure on a side opposite the light-emitting layer side and the light-emitting layer,
   the oxide confinement layer including:

    a non-oxidized region; and
    an oxidized region surrounding at least a part of the non-oxidized region, and
    the oxidized region has a plurality of tapered portions whose thickness decreases toward inner peripheral ends.

2. The surface-emitting element according to claim 1, wherein the plurality of tapered portions is located at different positions in a radial direction of the oxidized region.

3. The surface-emitting element according to claim 1, wherein the oxidized region has a first tapered portion as the tapered portion in an outer peripheral portion.

4. The surface-emitting element according to claim 3, wherein the oxidized region has a second tapered portion as the tapered portion in an inner peripheral portion.

5. The surface-emitting element according to claim 4, wherein a taper angle of the first tapered portion is larger than a taper angle of the second tapered portion.

6. The surface-emitting element according to claim 3, wherein

$$\mathrm{d1}(x_{11}) > \mathrm{d1}(x_{12}) > \cdots > \mathrm{d1}(x_{1n})$$

and/or

$$\mathrm{d2}(x_{11}) > \mathrm{d2}(x_{12}) > \cdots > \mathrm{d2}(x_{1n})$$

are satisfied, where a thickness of a first portion for each x-coordinate and a thickness of a second portion for each x-coordinate in a case where a plane located at an arbitrary position of the oxide confinement layer in a thickness direction and parallel to an in-plane direction is defined as a reference plane, a portion of the first tapered portion on one side of the reference plane is defined as the first portion, a portion on another side is defined as the second portion, and an x-axis is set in a direction from an outer peripheral end to an inner peripheral end of the oxidized region along the reference plane are denoted by d1(x) and d2(x), respectively, and $x11 < X12 < \cdots < x_{1n}$.

7. The surface-emitting element according to claim 3, wherein

$$[\{\mathrm{d1}(0) + \mathrm{d2}(0)\} - \{\mathrm{d1}(x_{1max}) + \mathrm{d2}(x_{1max})\}]/x_{1max} \geq$$

$$0.05$$

is satisfied, where a thickness of the first portion for each x-coordinate and a thickness of the second portion for each x-coordinate in a case where a plane located at an arbitrary position of the oxide confinement layer in a thickness direction and parallel to an in-plane direction is defined as a reference plane, an x-axis is set in a direction from an outer peripheral end to an inner peripheral end of the oxidized region along the reference plane, an x-coordinate of an outer peripheral end of the first tapered portion is 0, and an x-coordinate of an inner peripheral end of the first tapered portion is $x_{1max}$ are denoted by d1(x) and d2(x), respectively.

8. The surface-emitting element according to claim 4, wherein

$$[d1(x_{21}) + d2(x_{21})] > [d1(x_{22}) + d2(x_{22})] > \cdots > [d1(x_{2n}) + d2(x_{2n})]$$

are satisfied, where a thickness of a first portion for each x-coordinate and a thickness of a second portion for each x-coordinate in a case where a plane located at an arbitrary position of the oxide confinement layer in a thickness direction and parallel to an in-plane direction is defined as a reference plane, a portion of the second tapered portion on one side of the reference plane is defined as the first portion, a portion on another side is defined as the second portion, and an x-axis is set in a direction from an outer peripheral end to an inner peripheral end of the oxidized region along the reference plane are denoted by $d1(x)$ and $d2(x)$, respectively, and $X_{21} < X_{22} < \cdots < x_{2n}$.

9. The surface-emitting element according to claim 4, wherein the oxidized region has a middle peripheral portion between the outer peripheral portion and the inner peripheral portion.

10. The surface-emitting element according to claim 9, wherein the middle peripheral portion has a constant thickness.

11. The surface-emitting element according to claim 9, wherein the middle peripheral portion has a third tapered portion as the tapered portion.

12. The surface-emitting element according to claim 9, wherein

$$[d1(x_{31}) + d2(x_{31})] \geq [d1(x_{32}) + d2(x_{32})] \geq \cdots \geq [d1(x_{3n}) + d2(x_{3n})]$$

is satisfied, where a thickness of a first portion for each x-coordinate and a thickness of a second portion for each x-coordinate in a case where a plane located at an arbitrary position of the oxide confinement layer in a thickness direction and parallel to an in-plane direction is defined as a reference plane, a portion of the middle peripheral portion on one side of the reference plane is defined as the first portion, a portion on another side is defined as the second portion, and an x-axis is set in a direction from an outer peripheral end to an inner peripheral end of the oxidized region along the reference plane are denoted by $d1(x)$ and $d2(x)$, respectively, and $X_{31} < X_{32} < \cdots < x_{3n}$.

13. The surface-emitting element according to claim 11, wherein

$$[\{d1(x_{3min}) + d2(x_{3min})\} - \{d1(x_{3max}) + d2(x_{3max})\}] / (x_{3max} - x_{3min}) \leq 0.01$$

is satisfied, where a thickness of a first portion for each x-coordinate and a thickness of a second portion for each x-coordinate in a case where a plane located at an arbitrary position of the oxide confinement layer in a thickness direction and parallel to an in-plane direction is defined as a reference plane, a portion of the third tapered portion on one side of the reference plane is defined as the first portion, a portion on another side is defined as the second portion, an x-axis is set in a direction from an outer peripheral end to an inner peripheral end of the oxidized region along the reference plane, and an x-coordinate of an outer peripheral end of the third tapered portion is $x_{3min}$, and an x-coordinate of an inner peripheral end of the third tapered portion is $x_{3max}$ are denoted by $d1(x)$ and $d2(x)$, respectively.

14. The surface-emitting element according to claim 1, wherein at least one of the plurality of tapered portions is not parallel to an in-plane direction on both of one surface and another surface facing each other in a thickness direction.

15. The surface-emitting element according to claim 1, wherein at least one of the plurality of tapered portions is not parallel to an in-plane direction on one of one surface and another surface facing each other in a thickness direction and is parallel to the in-plane direction on another of the one surface and the another surface.

16. The surface-emitting element according to claim 1, wherein the non-oxidized region has a multilayer structure in which a plurality of semiconductor layers having different Al compositions is stacked.

17. The surface-emitting element according to claim 16, wherein, in the multilayer structure, the Al composition of the semiconductor layer at a predetermined position in a stacking direction of the first and second structures is the highest, and the Al composition of the semiconductor layer closer to the semiconductor layer at the predetermined position is higher.

**18.** The surface-emitting element according to claim 17, wherein

the plurality of semiconductor layers is an odd number of semiconductor layers, and
the predetermined position is a central position in the stacking direction.

**19.** The surface-emitting element according to claim 17, wherein

the plurality of semiconductor layers is at least three semiconductor layers, and
the predetermined position is a position of one end or another end in the stacking direction.

**20.** The surface-emitting element according to claim 17, wherein

the plurality of semiconductor layers is at least three semiconductor layers, and
the predetermined position is a position other than one end or another end in the stacking direction.

# FIG. 1

# FIG. 2

# FIG. 3

# FIG. 4

# FIG. 5

```
        ┌─────────────┐
        │    START    │
        └─────────────┘
               │
               ▼
   ┌───────────────────────────┐
   │ GENERATE MULTILAYER BODY  │────── S 1
   └───────────────────────────┘
               │
               ▼
      ┌─────────────────┐
      │    FORM MESA    │────── S 2
      └─────────────────┘
               │
               ▼
  ┌─────────────────────────────┐
  │ FORM OXIDE CONFINEMENT LAYER│────── S 3
  └─────────────────────────────┘
               │
               ▼
  ┌─────────────────────────────┐
  │    FORM CATHODE ELECTRODE   │────── S 4
  └─────────────────────────────┘
               │
               ▼
  ┌─────────────────────────────┐
  │    FORM ANODE ELECTRODE     │────── S 5
  └─────────────────────────────┘
               │
               ▼
        ┌─────────────┐
        │     END     │
        └─────────────┘
```

# FIG. 6

105

104

103S

102

101

# FIG. 7

# FIG. 8

# FIG. 9

# FIG. 10

# FIG. 11

# FIG. 12

# FIG. 13

# FIG. 14

103-3

103a4

103a3

103a2

103a

103a2

103a1

103b1 103b3 103b2

103b

# FIG. 15

# FIG. 16

# FIG. 17

# FIG. 18

# FIG. 19

# FIG. 20

# FIG. 21

# FIG. 22

# FIG. 23

# FIG. 24

# FIG. 25

# FIG. 26

# FIG. 27

# FIG. 28

# FIG. 29

# FIG. 30

# FIG. 31

# FIG. 32

# FIG. 33

# FIG. 34

SUBJECT
S

LENS
128

10
SURFACE-EMITTING
ELEMENT

125
LIGHT
RECEIVING
DEVICE

138
LENS

145
SIGNAL
PROCESSING
SECTION

DISTANCE MEASURING APPARATUS
1000

155
CONTROL
SECTION

165
DISPLAY
SECTION

175
STORAGE
SECTION

## FIG. 35

INTEGRATED CONTROL UNIT 12050

12051 MICROCOMPUTER

12052 SOUND/IMAGE OUTPUT SECTION

IN-VEHICLE NETWORK I/F 12053

AUDIO SPEAKER 12061

DISPLAY SECTION 12062

INSTRUMENT PANEL 12063

12000

12001 COMMUNICATION NETWORK

DRIVING SYSTEM CONTROL UNIT 12010

BODY SYSTEM CONTROL UNIT 12020

OUTSIDE-VEHICLE INFORMATION DETECTING UNIT 12030

IN-VEHICLE INFORMATION DETECTING UNIT 12040

DISTANCE MEASURING APPARATUS 12031

DRIVER STATE DETECTING SECTION 12041

# FIG. 36

## INTERNATIONAL SEARCH REPORT

| International application No. |
| --- |
| **PCT/JP2024/014537** |

| A. | CLASSIFICATION OF SUBJECT MATTER |
| --- | --- |

*H01S 5/183*(2006.01)i; *H01L 33/14*(2010.01)i
FI: H01S5/183; H01L33/14

According to International Patent Classification (IPC) or to both national classification and IPC

| B. | FIELDS SEARCHED |
| --- | --- |

Minimum documentation searched (classification system followed by classification symbols)

H01S5/183; H01L33/14

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2012-216664 A (THE FURUKAWA ELECTRIC CO., LTD.) 08 November 2012 (2012-11-08)<br>paragraphs [0026]-[0028], [0041]-[0045] fig. 7, 9 | 1-4, 6, 8-9, 11-12, 14, 16-17, 20 |
| A | | 5, 7, 10, 13, 15, 18-19 |
| X | JP 2004-356438 A (HAMAMATSU PHOTONICS K.K.) 16 December 2004 (2004-12-16)<br>paragraphs [0026]-[0034] fig. 1-4 | 1-2, 14-15 |
| X | JP 2000-22204 A (KABUSHIKI KAISHA TOSHIBA) 21 January 2000 (2000-01-21)<br>paragraphs [0050]-[0053] fig. 4 | 1-5, 7, 9, 11, 14, 16-17, 20 |
| A | JP 2016-46453 A (FUJI XEROX CO., LTD.) 04 April 2016 (2016-04-04) | 1-20 |
| A | JP 2008-192733 A (FUJI XEROX CO., LTD.) 21 August 2008 (2008-08-21) | 1-20 |
| A | JP 2009-206480 A (RICOH COMPANY, LTD.) 10 September 2009 (2009-09-10) | 1-20 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **25 April 2024** | **14 May 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/014537**

| Patent document cited in search report | | | Publication date (day/month/year) | Patent family member(s) | | | Publication date (day/month/year) |
|---|---|---|---|---|---|---|---|
| JP | 2012-216664 | A | 08 November 2012 | US | 2012/0251039 | A1 | |
| | | | | paragraphs [0048]-[0050], [0063]-[0067] fig. 7, 9 | | | |
| JP | 2004-356438 | A | 16 December 2004 | (Family: none) | | | |
| JP | 2000-22204 | A | 21 January 2000 | (Family: none) | | | |
| JP | 2016-46453 | A | 04 April 2016 | US | 2016/0064900 | A1 | |
| JP | 2008-192733 | A | 21 August 2008 | US | 2008/0187015 | A1 | |
| | | | | KR | 10-2008-0072499 | A | |
| | | | | CN | 101237123 | A | |
| JP | 2009-206480 | A | 10 September 2009 | US | 2010/0189467 | A1 | |
| | | | | KR | 10-2010-0024515 | A | |
| | | | | CN | 101765951 | A | |

Form PCT/ISA/210 (patent family annex) (July 2022)

**EP 4 716 037 A1**

## REFERENCES CITED IN THE DESCRIPTION

**Patent documents cited in the description**

- JP 2004356438 A

- JP 2009206480 A